# EUROPEAN PATENT SPECIFICATION

(11) **EP 0 559 141 B1**
(45) Date of publication and mention of the grant of the patent: **10.06.1998**
(21) Application number: 93103291.6
(22) Date of filing: 02.03.1993
(51) Int. Cl.: H01L 31/0216, H01L 31/0224, H01L 31/075, H01L 31/052

(54) **Photovoltaic device**
Photovoltaische Vorrichtung
Dispositif photovoltaique

(30) Priority: 03.03.1992 JP 81715/92
(43) Date of publication of application: 08.09.1993
(73) Proprietor: CANON KABUSHIKI KAISHA, Tokyo (JP)
(72) Inventor: Ishikawa, Nobuyuki, c/o Canon Kabushiki Kaisha, Ohta-ku, Tokyo 146 (JP); Saito, Keishi, c/o Canon Kabushiki Kaisha, Ohta-ku, Tokyo 146 (JP); Kawakami, Soichiro, c/o Canon Kabushiki Kaisha, Ohta-ku, Tokyo 146 (JP); Matsuyama, Jinsho, c/o Canon Kabushiki Kaisha, Ohta-ku, Tokyo 146 (JP); Kariya, Toshimitsu, c/o Canon Kabushiki Kaisha, Ohta-ku, Tokyo 146 (JP); Kohda, Yuzo, c/o Canon Kabushiki Kaisha, Ohta-ku, Tokyo 146 (JP); Okada, Naoto, c/o Canon Kabushiki Kaisha, Ohta-ku, Tokyo 146 (JP)
(74) Representative: Tiedtke, Harro, Dipl.-Ing.

(56) References cited:
- EP-A- 0 054 157
- GB-A- 2 098 002
- PATENT ABSTRACTS OF JAPAN vol. 14, no. 451 (E-984)27 September 1990 & JP-A-2 180 081 ( TAIYO YUDEN CO LTD ) 12 July 1990
- PATENT ABSTRACTS OF JAPAN vol. 11, no. 257 (E-534)20 August 1987 & JP-A-62 065 478 ( SANYO ELECTRIC CO LTD ) 24 March 1987
- PATENT ABSTRACTS OF JAPAN vol. 14, no. 102 (E-894)23 February 1990 & JP-A-1 304 755 ( MITSUBISHI ELECTRIC CORP ) 8 December 1989
- PATENT ABSTRACTS OF JAPAN vol. 7, no. 162 (E-187)15 July 1983 & JP-A-58 070 581 ( SHARP KK ) 27 April 1983

## Description

### BACKGROUND OF THE INVENTION

### Field of the Invention

The present invention relates to a photovoltaic device, and more particularly to a surface coating which reveals excellent weather resistance and impact resistance and which is applied to a photovoltaic device having a semiconductor layer and an electrode layer serving as photoelectric conversion members formed on a base member thereof, and to a photovoltaic device, the output characteristics of which are improved because light to be absorbed by the semiconductor layer can be utilized effectively by scattering incident light.

### Related Background Art

Recently, there has been expected that the earth will be warmed by a green-house effect due to an increase in CO₂ and therefore there further arises a desire for clean energy. Since the nuclear power generation has encountered an unsolved problem of the way of disposing the radioactive waste, more safety and clean energy has been required. Among various clean energies expected for future use, the solar cell has been expected due to its cleanness, safety and handling facility.

Among others, amorphous silicon and copper indium selenide has been energetically studied because a large area cell can be manufactured and the manufacturing cost can be reduced.

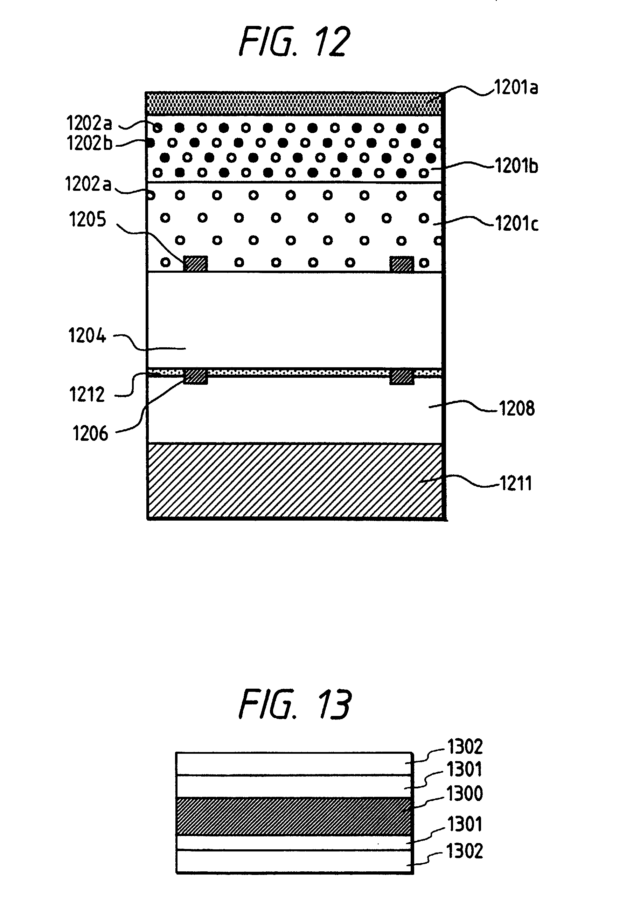

The solar cells sometimes use substrates made of metal such as stainless steel because of its capability of reducing weight, and excellent weather resistance, impact resistance and flexibility. If the metal substrate made of, for example, stainless steel is employed, at least the light incident surface must be covered with a coating, which is transparent with respect to visible light, in a manner different from the case in which the glass substrate is employed. As shown in a schematic cross sectional view of Fig. 13 which illustrates a conventional solar cell module, the conventional solar cell module has an arrangement that a solar cell 1300 is laminated with fluororesin films 1302 exhibiting excellent weather resistance while interposing adhesive layers 1301 also serving as fillers made of EVA (ethylene acetate vinyl copolymer).

However, the fact that the EVA and fluororesin film have low hardness causes scratching damage and the like to be easily generated. Accordingly, the EVA layers and the fluororesin films are thickened in order to protect the body of the solar cell from the damage. In order to improve the hardness and strength, a structure is sometimes employed in which unwoven glass fabric such as crane glass is stacked as a filler in the form embedded in the EVA layer. However, there arises a problem in that the weight cannot be reduced if the EVA serving as the adhesive agent and also serving as the filler or the total thickness of the EVA layer and the crane glass is too thick.

In an outdoor experiment to which the resin film laminated-type solar cell module is subjected, a problem takes place in that small spaces are undesirably formed between the resin film and the adhesive agent for adhering the resin film to the solar cell and therefore the resin film is locally separated.

In order to overcome the foregoing problem, a method has been disclosed in Japanese Patent Laid-Open Application No. 59-73942. The disclosure has an arrangement that a surface which is in contact with the adhesive agent layer made of a fluororesin film or an ethylene chloride trifluoride resin film is subjected to an RF sputtering etching. Furthermore, the solar cell is covered with the foregoing films and the adhesive agent to improve the adhesive strength. However, the structure is inevitably made to be a multi-layer and the RF sputtering etching process must be performed. Therefore, a complicated manufacturing process is required.

Another method for further reducing the weight has been attempted in such a way that a fluororesin paint exhibiting weather resistance is used to directly cover the light incident surface of the solar cell in place of the fluororesin film and the adhesive layer. However, the fact that the fluororesin has insufficient hardness causes a problem of damage. Therefore, the aforesaid method cannot be adapted to a solar cell to be used outdoors.

A method of improving the photoelectric conversion efficiency of a photovoltaic device such as a solar cell incorporating a semiconductor layer for generating photovoltaic force and electrodes has been disclosed. The method has an arrangement that light incident on the photovoltaic device is scattered to lengthen the optical path in the semiconductor layer, to enlarge the quantity of light to be absorbed in the semiconductor layer, and to enlarge the short-circuit electric current.

The structure of the photovoltaic device for scattering light incident on the photovoltaic device is exemplified by: a structure in which a transparent electrode having projections and pits is formed on a transparent substrate such as a glass substrate; a structure in which a light reflection layer having projections and pits is formed on the substrate; and a structure in which a semiconductor substrate having projections and pits formed therein is used. The structure using the glass substrate or the semiconductor substrate scatters light on the surface of the light incident side thereof. The structure having the projections and pits formed in the light reflection layer scatters the light on the reverse side of the light incident side thereof.

The structure incorporating the glass substrate to scatter the light on the surface of the light incident side has an arrangement that light is incident upon the semiconductor layer through the substrate. Therefore, a transparent electrode having the projections and pits is formed with heat at a temperature of about 300°C or more prior to forming the semiconductor layer.

On the other hand, the photovoltaic device having the structure in which light is incident on the semiconductor layer through a portion opposing the substrate is manufactured as follows: first, a thin semiconductor layer is formed on the substrate; and then, structure for scattering light is formed. Therefore, the temperature of the substrate cannot be raised to a level higher than the temperature at which the semiconductor layer is formed at the time of forming the transparent electrode. What is worse, the transparent electrode having the projections and pits cannot easily be formed though they can easily be formed in the glass substrate. If the transparent electrode also has a function to also serve as the reflection protection layer, the reflectance is lowered in a wide wavelength range by usually thinning the optical thickness (nd) of the transparent electrode to λ/4 (λ is a wavelength which minimizes the reflectance). In the foregoing case, the transparent electrode is too thin to form the projections and pits.

The EP-A-0 054 157 discloses a photovoltaic device comprising a semiconductor layer, the surface layer of which has a rip-like structure comprising spaced-apart vertical gaps being filled with a solar radiation transmissive material which contains scattering granules in a dispersed state.

If the semiconductor having the projections and pits for scattering light formed thereon is used, the substrate must be handled delicately. Therefore, there arises a problem in that the number of the manufacture process increases and the manufacturing cost is enlarged accordingly.

As described above, the photovoltaic devices except for that having a structure in which light is incident on the semiconductor layer from the glass substrate encounter a problem that the structure for scattering light on the surface on the light incident side cannot easily be employed due to limits present to maintain the manufacturing facility and to reduce cost.

However, there has been a desire of improving the photoelectric conversion efficiency of the photovoltaic device which uses a low cost substrate such as a stainless steel substrate or a synthetic resin film except for the glass substrate in order to practically use a low cost photovoltaic device which can be adapted to wide use typified by electric power generation. Therefore, it has been a desire of forming the structure for scattering light on the surface on the light incident side of the photovoltaic device using a low cost substrate except for the glass substrate.

### SUMMARY OF THE INVENTION

Accordingly, an object of the present invention is to provide a photovoltaic device which has a structure for scattering light on the surface of the light incident side thereof, which can not easily be damaged by scratching, which can be used outdoors, the weight of which can be reduced, and which exhibits stable performance.

In order to solve this object, a photovoltaic device according to the present invention as set forth in claim 1 is provided. Specifically, the granules are dispersed sparsely in the vicinity of the light incident side of the surface protection layer and densely in the inner portion of the surface protection layer, or the granules are dispersed densely in the vicinity of the light incident side of the surface protection layer and sparsely in the inner portion of the surface protection layer.

Furthermore, the arrangement is characterized in that the granules are disposed into one layer or a plurality of layers in the surface protection layer.

The granules may be two-or more types of granules depending upon the material.

In order to improve the effect of enclosing light due to the scatter of light, it is necessary for the difference between the refraction factor of the material of the granules and that of the material of the surface protection layer to be 0.1 or more. It is preferable that the refraction factor of the surface protection layer increases adjacently to that of the granules.

The photovoltaic device according to an embodiment of the present invention is characterized in that a light reflection layer is formed to oppose the surface of the semiconductor layer on which light is incident, the light reflection layer having a structure for scattering light.

Other and further objects, features and advantages of the invention will be appear more fully from the following description.

### BRIEF DESCRIPTION OF THE DRAWINGS

Fig. 1 is a schematic view which illustrates a photovoltaic apparatus according to the present invention;
Fig. 2 is a schematic cross sectional view which illustrates an example of a photovoltaic element for use in the photovoltaic device according to the present invention;
Fig. 3 is a schematic cross sectional view which illustrates an example of the photovoltaic device according to the present invention;
Fig. 4 is a plan schematic view which illustrates an example of the photovoltaic device according to the present invention;
Fig. 5 is a graph showing the relationship between the average particle size of granules of the photovolatic device according to the present invention and standardized short-circuit current (Jsc);
Fig. 6 is a graph showing the relationship between the surface density of granules of the photovoltaic device according to the present invention disposed to form a layer and standardized short-circuit current (Jsc);
Fig. 7 is a graph showing the spectrum sensitivity of an example of the photovoltaic device according to the present invention;
Fig. 8 is a schematic cross sectional view which illustrates a reference example of the photovoltaic device;
Fig. 9 is a graph which illustrates the relationship between the density per volume of the granules uniformly contained in the surface protection layer of a photovoltaic device and the standardized short-circuit current (Jsc);
Fig. 10 is a schematic cross sectional view which illustrates another example of the photovoltaic device according to the present invention;
Fig. 11 is a schematic cross sectional view which illustrates another example of the photovoltaic device according to the present invention;
Fig. 12 is a schematic cross sectional view which illustrates another example of the photovoltaic device according to the present invention; and
Fig. 13 is a schematic cross sectional view which illustrates an example of a conventional solar cell module.

### DETAILED DESCRIPTION OF THE PREFERRED EMBODIMENT

The structure of a photovoltaic device according to the present invention will now be described with reference to the drawings.

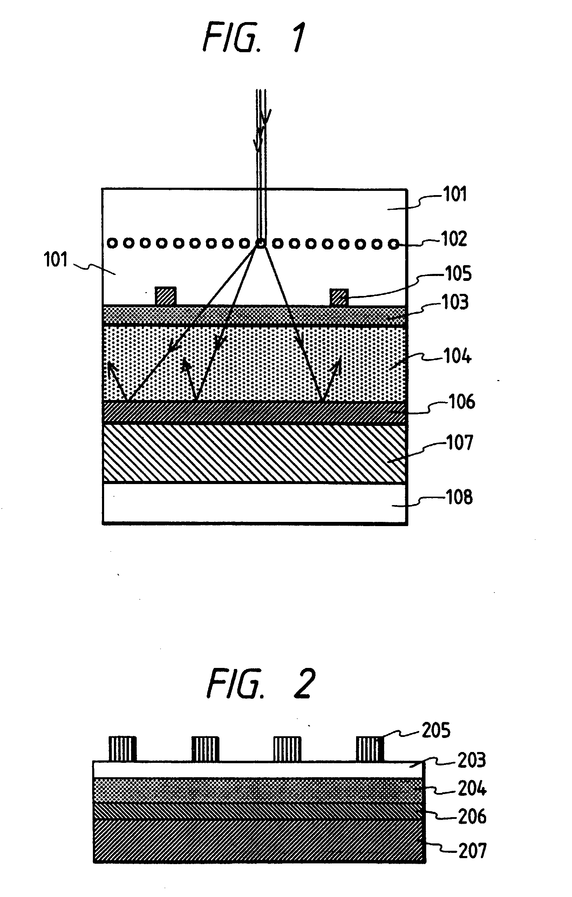

Fig. 1 is a cross sectional view which illustrates an example of the structure of a photovoltaic device according to the present invention The density variation of the granules as set forth in claim 1 is not specifically shown in Fig. 1 but will be described later on. Referring to Fig. 1, reference numeral 101 represents a surface protection layer, 102 represents granules, 103 represents a transparent electrode, 104 represents a semiconductor layer, 105 represents a collecting electrode, 106 represents a reverse electrode, 107 represents a substrate, and 108 represents a reverse-side protection layer.

### (Surface Protection Layer)

The surface protection layer 101 according to the present invention is formed on the surface of the photovoltaic device to protect it from external environment, the surface protection layer 101 being made of a material exhibiting weather resistance selected from photosynthetic resins. It is preferable that transmittance, at which the material permits light having the wavelength that can be sensitized by the photovoltaic device, is 80 % or more, more preferably 90 % or more on average, most preferably 95 % or more on average. Furthermore, it is preferable that the transmittance of the material cannot deteriorate excessively even if the material is allowed to stand outdoors for a long time.

It is preferable that the surface protection layer according to the present invention is formed by applying liquid resin containing granules. As an alternative to this, a method may be employed in which a resin containing granules is formed into a film followed by adhering the film by an adhesive agent. Specifically, any one of the following methods may be employed: a screen method, a dipping method, a rolling method, a spraying method and a dying method.

In order to cause the granules to be easily disposed in or mixed with the surface protection layer, it is most preferable that the material of the photovoltaic device according to the present invention is a material which is melted when heated and which is exemplified by; silicon resin, PVB (polyvinyl butyral), fluororesin coating, acrylic resin, acrylic silicon resin, and inorganic glass coating material. As an alternative to this, a material which can be dissolved by a solvent preferably to be applied may be employed.

By rapidly cooling the molten material of the surface protection layer or by rapidly drying the solvent for the material of the surface protection layer dissolved by the same, the refraction factor of the surface protection layer adjacent to the granules can be increased. It can be considered that the reason for this is that stress acts on the surface protection layer adjacent to the granules.

The surface protection layer 101 may be formed such that it is divided into an upper transparent member, a filler, and an adhesive agent depending upon the functions. As for a preferred material to form the upper transparent member, anyone of the following materials is employed: a fluororesin such as glass, acryl, polycarbonate, FRP, and PVF (polyvinyl fluoride) and the like; or a silicon resin or the like. It is preferable that the filler is made of, for example, a silicon resin, PVB (polyvinyl butyral), and EVA (ethylene vinylacetate), and the like.

In order to protect the photovoltaic device from scratch type damage, it is preferable that the thickness is 0.5 µm or more, more preferably 1 µm or more. In a case where the photovoltaic device according to the present invention is incorporated in a solar cell module to be also used as an incombustible exterior material for a building, and in order to maintain resistance against cracks, it is preferable that the thickness of the surface protection layer is 400 µm or less, more preferable 300 µm or less.

The surface protection layer may contain ultraviolet light absorber in order to prevent deterioration due to ultraviolet light and may contain a primer for the purpose of improve adhesion.

### (Granules)

The granules 102 are caused to present in the form of a layer in the surface protection layer or to be dispersed in the same, provided that the granules are dispersed at different density in the thickness direction of the surface protection layer as set forth in claim 1.

The granules 102 can be dispersed in the surface protection layer by previously mixing the granules in the molten surface protection layer followed by applying the surface protection layer.

If the granules 102 is disposed in the surface protection layer while being formed into a layer, a surface protection layer is formed, and the granules 102 are allowed to adhere to the surface of the surface protection layer followed by forming a second surface protection layer. If the foregoing process is repeated several times, a plurality of granule layers can be formed in the surface protection layer.

If the distribution density of the granules is varied in the surface protection layer, two or more surface protection layers, which are different from each other in the density at which the granules are mixed, are formed by application. As an alternative to this, the variation can be realized by dispersing the granules in the surface of the molten surface protection layer followed by sedimentation of the granules.

If a plurality of granule layers are formed in the surface protection layer, or if two or more different types of surface protection layers with which the granules are mixed are applied, the granule material may be permitted to be different depending upon the layers.

It is preferable that the average diameter of the granules is 0.001 µm to 20 µm, more preferably 0.005 µm to 10 µm. If the light scatter is enhanced, it is preferable that the average size of the granules is 0.3 µm to 5 µm.

If the granule layer is formed in the surface protection layer, the density of the granules in the surface protection layer is assumed to be the surface density S. In this case, it is preferable that value of S is 0.2 to 0.9, more preferable 0.4 to 0.9, the value S being a ratio at which the light incidental surface of the photovoltaic device is covered with the granules when the granules dispersed in the layer form are viewed from the light incidental direction. If the surface lensity of the granules in the surface protection layer is too low, the scatter of light due to the granules cannot be taken place sufficiently. If the surface density is higher than 0.9, the adhesion of the surface protection layer on the granules formed in the layer deteriorates.

If the granules are dispersed at different density, the density per volume, that is, the volume V of the granules in the surface protection layer is 0.001 to 0.5, preferably 0.01 to 0.3. If the density of the granules in the surface protection layer is too low, the scatter of light due to the granules cannot take place sufficiently. If the density is too high, the total transmittance of the surface protection layer deteriorates.

The granules 102 may be disposed at any position in the surface protection layer 101 in a range from a position adjacent to the surface to a position adjacent to the electrode 103.

In order to improve the effect of enclosing incident light by scattering the same, it is preferable that the refraction factor of the granules 102 is different by 0.1 or more from the refraction factor of the surface protection layer 101, more preferably 0.2 or more from the same, most preferably 0.3 or more from the same. It is preferable that the material of the granules 102 exhibits a transmittance of light having a wavelength of 400 nm to 1000 nm is 80 % on average, more preferably 90 % or more on average, most preferably 95 % or more on average.

Since the foregoing materials preferably employed to form the surface protection layer 101 usually have a refraction factor of about 1.5 or more, it is preferable that the material of the granules 102 exhibits a refraction factor of about 1.0 to 3.0, more preferably 1.2 to 2.5. Since the materials that have the refraction factors in the foregoing range usually have the transmissivity of light having a wavelength from 400 nm to 1000 nm, the foregoing material can be used preferably in this viewpoint. Since materials that exhibit a refraction factor of 2.5 cannot realize the foregoing light transmittance of light having a wavelength from 400 nm to 1000 nm, such materials must be omitted from the group to be selected.

Furthermore, it is preferable that the material of the granules 102 exhibits excellent adhesion with the material of the surface protection layer 101, excellent chemical stability and a thermal expansion coefficient approximating that of the material of the surface protection layer 101.

Specifically, the granules 102 is preferably made of a material selected from a group consisting of: ZnS, TiO₂, Ta₂O₅, CeO₂, ZrO₂, Sb₂O₃, Nd₂O₃, In₂O₃, SiC, Si₃N₄, SiO, La₂O₃, SnO₂, ZnO, CdO, Cd₂SnO₄, ThO₂, MgO, Al₂O₃, CaO, BaO, Y₂O₃, Eu₂O₃, Pr₂O₃, Gd₂O₃, Tb₂O₃, Pr₆O₁₁, Dy₂O₃, Yb₂O₃, Er₂O₃, Ho₂O₃, CeF₃, PbF₂, NdF₃, LaF₂, MgF₂, LiF, Na₃AlF₆, NaF, and CaF₂ and the like or their mixtures.

If any one of the aforesaid materials is combined with a material for the surface protection layer selected from a group consisting of, for example, a silicon resin, PVB (polyvinyl butyral) and EVA (ethylene vinyl acetate, characteristics revealing excellent adhesion and chemical stability can be attained, resulting in a preferred effect.

A method for forming the granules 102 is exemplified by: a gas phase reaction method such as an electric furnace method, a chemical flame method, a plasma method, and a laser method; an evaporation and condensation method such as a resistance heating method, a plasma heating method, an RF induction heating method, an electronic beam heating method, a laser beam heating method, and a sputtering method; a precipitation method such as a coprecipiration method, a hydrolysis method, a homogenous precipitation method, an oxidation hydrosys method, and a deoxidation method; a solvent evaporation method such as a freeze drying method, a spray drying method, a spray heat decomposition method; and an atomizing method. In particular, it is preferable that the gas phase reaction method or the evaporation and condensation method is employed.

The shape of the granules may be sphere, column, square column, plate, or indeterminate form. In particular, granules in the form of the square columnar shape, the plate shape or the indeterminate form cause light to be scattered satisfactorily.

The granules may be crystalline granules or cluster composed of a plurality of crystalline granules. In particular, satisfactory scatter of light can be attained from the cluster.

The density per volume of the granules to be dispersed in the surface protection layer can be varied by a method in which prepared surface protection layers having different densities per volume are stacked; or a method in which the surface protection layer containing the granules is applied to the surface of the photovoltaic device, then a potential is generated in the surface of the photovoltaic device by biasing the surface protection layer or by irradiating the same with light while melting or maintaining the dissolved state of the surface protection layer, and then the potential is changed with time.

### (Transparent Electrode)

The transparent electrode 103 according to the present invention serves as a light incidental side electrode through which light is transmitted and also serves as a reflection protection film by optimizing the thickness. The transparent electrode 103 must have a high transmittance in a wavelength region which can be absorbed by the semiconductor layer and a low resistivity. It is preferable that the transmittance at 550 nm is 80 % or higher, more preferably 85 %. It is preferable that the resistivity is 5 x 10⁻³ Ωcm or lower, more preferably 1 x 10⁻³ Ωcm or lower. The material may be a conductive oxide such as In₂O₃, SnO₂, ITO (In₂O₃ + SnO₂), ZnO, CdO, Cd₂SnO₄, TiO₂, Ta₂O₅, Bi₂O₃, MoO₃, and Na₂WO₃ and the like or their mixtures. An element (dopant) for changing the conductivity may be added to the foregoing compound.

As the element (dopant) for changing the conductivity, any one of the following elements may be employed if the transparent electrode 103 is made of ZnO: Al, In, B, Ga, Si, or F or the like. If the transparent electrode 103 is made of In₂O₃, Sn, F, Te, Ti, Sb or Pb or the like is employed. If the transparent electrode 103 is made of SnO₂, FSb, P, As, In, Tl, Te, W, Cl, Br or I or the like is employed.

The method of forming the transparent electrode 103 may be an evaporation method, a CVD method, a spray method, a spin-on method or a dip method or the like.

### (Semiconductor Layer)

The semiconductor layer 104 according to the present invention is made of any one of materials categorized into crystalline material, polycrystalline material, amorphous material or their mixture, the material being formed into a thin film or a bulk for use. The material of the semiconductor layer 104 may be: an element in group IV such as Si, C, and Ge, and the like; an alloy in group IV such as SiGe, SiC, and SiSn, and the like; an element in group III-V such as GaAs, InSb, Gap, GaSb, InP, and InAs, and the like; an element in group II-VI such as ZnSe, CdTe, ZnS, AnTe, CdS, CdSe and CdTe, and the like; or an element in group I-III-VI such as CuInSe₂; or their mixtures.

Among the foregoing semiconductor materials, any one of the following semiconductor materials may be adapted to the photovoltaic device according to the present invention: an element in group IV and an alloy type amorphous semiconductor in group IV such as a-Si:H (amorphous silicon hydride), a-Si:F, a-Si:H:F, a-SiGe:H, a-SiGe:F, a-SiGe:H:F, a-SiC:H, a-SiC:F, and a-SiC:H:F, and the like; and a so-called polycrystalline semiconductor material in group IV or an alloy-type polycrystalline semiconductor material in group IV such as polycrystalline Si, polycrystal Si:H, and polycrystalline Si:H:F and the like. It can be considered that the effect of enhancing the light absorption in the semiconductor layer is improved by the light distribution of the granules according to the present invention thanks to the light enhancing effect if the semiconductor layer is a thin film having a thickness of 2.0 µm or less because the preferred thickness of the semiconductor layer made of an element in group IV and an alloy-type amorphous semiconductor material in group IV is from 0.1 µm to 50 µm.

At least a portion of the semiconductor layer 104 is doped to p-type or n-type by controlling valence electrons so that one or more pairs of pn junctions or pin junctions are formed. That is, a so-called stack cell structure may be formed which is constituted by stacking a plurality of pn junction layers or pin junction layers.

The semiconductor layer 104 may be formed by any one of the following methods: a CVD method exemplified by a microwave plasma CVD method, an RF plasma CVD method, an optical CVD method, a heat CVD method, and a MOCVD method; an evaporation method exemplified by an EB evaporation method, an MBE method, an ion plating method and an ion beam method; a sputtering method; a spraying method; and a printing method.

The semiconductor layer employing the element in group IV and the alloy-type semiconductor amorphous semiconductor material in group IV adaptable to the photovoltaic device according to the present invention will now be described further in detail.

### (1) i-type layer (a true semiconductor layer)

The i-type layer for use in the pin junction in the photovoltaic device which uses an element in group IV and the amorphous semiconductor material in group IV is an important layer for generating and transporting a carrier when irradiated with light. The i-type layer may employ a slightly p-type layer or a slightly n-type layer.

The element in group IV and the alloy-type amorphous semiconductor material in group IV contains hydrogen atoms (H,D) or halogen atoms (X) as described above, hydrogen atoms (H,D) or halogen atoms (X) serving as an important role.

Hydrogen atoms (H, D) or halogen atoms (X) contained in the i-type layer act to compensate the unbonded hands of the i-type layer and to improve the product of the mobility of the carrier and the durability in the i-type layer. Furthermore, hydrogen atoms (H, D) or halogen atoms (X) act to compensate the interfacial level between the p-type layer and the i-type layer and between the n-type layer and the i-type layer to enlarge the photovoltaic force and the photoelectric currents of the photovoltaic device and to improve the optical response. It is preferable that the quantity of hydrogen atoms and/or halogen atoms contained in the i-type layer is from 1 to 40 atm%. In particular, it is preferable that a large quantity of hydrogen atoms and/or halogen atoms is distributed adjacent to the interface between the p-type layer and the i-type layer and that between the n-type layer and the i-type layer. It is preferable that the content of hydrogen atoms and/or halogen atoms adjacent to the foregoing interfaces is 1.1 to 2 times the content of those in the bulk. Furthermore, it is preferable that the content of hydrogen atoms and/or halogen atoms is varied with respect to the content of silicon atoms.

The thickness of the i-type layer considerably depends upon the structure (for example, single cell, double cell or triple cell) of the photovoltaic device and depends upon the band gap of the i-type layer. However, it is preferable that the thickness is from 0.05 to 1.0 µm.

More specifically, amorphous silicon (a-Si:H) for the i-type layer adaptable to the photovoltaic device according to the present invention is as follows: optical band gap (Eg) is 1.60 eV to 1.85 eV; content (C_{H}) of hydrogen atoms is 1.0 to 25.0 %; light conductivity (σₚ) under pseudo solar light of AM 1.5 and 100 mW/cm² is 1.0 x 10⁻⁵ S/cm or more; dark conductivity (σ_{d}) is 1.0 x 10⁻⁹ S/cm or less; the inclination of the abacktail in a constant photo-method (CPM) is 55 meV or less; and the density of the unbonded hand in electronic spin resonation (ESR) is 10¹⁷/cm³ or less.

I-type amorphous silicon germanium adaptable to the photovoltaic device according to the present invention is as follows: optical band gap (Eg) is 1.35 eV to 1.70 eV; content (C_{H}) of hydrogen atoms is 1.0 to 20.0 %; light conductivity (σₚ) under pseudo solar light of AM 1.5 and 100 mW/cm² is 1.0 x 10⁻⁷ S/cm or more; dark conductivity (σ_{d}) is 1.0 x 10⁻⁸ S/cm or less; the inclination of the abacktail in a constant photo-method (CPM) is 60 meV or less; and the density of the unbonded hand in electronic spin resonation (ESR) is 10¹⁷/cm³ or less.

By using the element in group IV and the alloy type amorphous semiconductor material in group IV, the transportation characteristics of the optical carrier can be improved. As a result, the sensitivity of long-wavelength light can be improved, and the effect of enhancing the light absorption in the semiconductor layer thanks to the scatter of light due to the granules according to the present invention can be improved due to a synergistic effect. Therefore, the characteristics of the photovoltaic device can be further improved. The reason for this can be considered that, if attainment of the foregoing characteristics lowers a so-called local level in the semiconductor layer and the length of the optical path through which light scattered by the granules pass through is lengthened, the optical carriers are not again bonded but are effectively accumulated to enhance the effect of improving the sensitivity of the photovoltaic device for sensing the long wavelength light.

### (2) p-Type Layer or n-Type Layer

The amorphous material (hereinafter expressed as "a-") for the p-type layer or the n-type layer (microcrystalline material (hereinafter expressed as "µc-") is also included in a category of the amorphous material) is exemplified by a material composed of any one of the following material: a-Si:H, a-Si:HX, a-SiC:H, a-SiC:HX, a-SiGe:H, a-SiGeC:H, a-SiO:H, a-SiN:H, a-SiON:HX, a-SiOCN:HX, µc-Si:H, µc-SiC:H, µc-Si:HX, µc-SiC:HX, µc-SiGe:H, µc-SiO:H, µc-SiGeC:H, µc-SiN:H, µc-SiON:HX, or µc-SiOCN:HX; and p-type valence electron control agent (B, Al, Ga, In or Tl in group III of the periodic table) or n-type valence electron control agent (P, As, Sb or Bi in group V of the periodic table) added to any one of the foregoing materials at a high concentration. The polycrystalline material is exemplified by a material composed of any one of the following materials: poly-Si:H, poly-Si:HX, poly-SiC:H, poly-SiC:HX, poly-SiGe:H, poly-Si, poly-SiC, or poly-SiGe; and p-type valence electron control agent (B, Al, Ga, In or Tl in group III of the periodic table) or n-type valence electron control agent (P, As, Sb or Bi in group V of the periodic table) added to any one of the foregoing materials at a high concentration.

In particular, it is preferable that the p-type layer or the n-type layer on the light incidental side is made of a crystalline semiconductor layer which does not absorb light considerably or an amorphous semiconductor layer having a wide band gap.

The optimum quantity of the element in group III of the periodic table to the p-type layer and that of the element in group V of the same to the n-type layer is from 1 to 50 atm%.

Hydrogen atoms (H, D) or halogen atoms contained in the p-type layer or the n-type layer compensate unbonded hands in the p-type layer or the n-type layer to improve the doping efficiency of the p-type layer or the n-type layer. The optimum quantity of hydrogen atoms or halogen atoms to be added to the p-type layer or the n-type layer is from 0.1 to 40 atm%. In particular, if the p-type layer or the n-type layer is a crystalline layer, the optimum quantity of hydrogen atoms or halogen atoms is from 0.1 to 8 atm%. Furthermore, it is preferable that a large quantity of hydrogen atoms and/or halogen atoms is distributed adjacent to the interface between the p-type layer and the i-type layer and that between the n-type layer and the i-type layer. It is preferable that the content of hydrogen atoms and/or halogen atoms adjacent to the foregoing interfaces is 1.1 to 2 times the content of those in the bulk. By enlarging the content of hydrogen atoms or halogen atoms adjacent to the interfaces between the p-type layer and the i-type layer and between the n-type layer and the i-type layer as described above, defective levels and mechanical strain can be reduced. As a result, the photovoltaic force and the photoelectric current of the photovoltaic device according to the present invention can be enlarged.

As for the electric characteristics of the p-type layer and the n-type layer of the photovoltaic device, it is preferable that the activation energy is 0.2 eV or less, more preferably 0.1 eV or less. It is preferable that the specific resistance is 100 Ωcm or less, more preferably 1 Ωcm or less. Furthermore, it is preferable that the thickness of the p-type layer and that of the n-type layer is from 1 to 50 nm, more preferably 3 to 10 nm.

The optimum method of manufacturing the semiconductor layer of the photovoltaic device according to the present invention and made of the element in group IV and the alloy-type amorphous in group IV is a microwave plasma CVD method, and secondary preferable method as an RF plasma CVD method.

The microwave plasma CVD method having the steps of: introducing raw material gases such as a raw material gas and a dilution gas into a deposition chamber (a vacuum chamber), the pressure of which can be lowered; making the internal pressure in the deposition chamber while exhausting the deposition chamber by using a vacuum pump; and introducing microwaves oscillated by a microwave power source into the deposition chamber through a wave guide pipe and a dielectric window (made of alumina ceramics or the like) to cause plasma of the raw material gas to be generated to decompose the raw material. As a result, a desired deposited film is formed on a substrate disposed in the deposition chamber. With the foregoing method, a deposited film adaptable to the photovolatic device and revealing wide deposition conditions can be formed.

If the semiconductor layer of the photovoltaic device according to the present invention is deposited by the microwave plasma CVD method, the preferred deposition conditions are as follows: the temperature of the substrate in the deposition chamber is from 100 to 450°C, the internal pressure is from 0.5 to 30 mTorr, the power of the microwaves is 0.01 to 1 W/cm², and the frequency of the microwaves is from 0.5 to 10 GHz.

If the semiconductor layer is deposited by the RF plasma CVD method, the preferred deposition conditions are as follows: the temperature of the substrate in the deposition chamber is from 100 to 350°C, the internal pressure is from 0.1 to 10 Torr, the power of the RF waves is 0.01 to 5.0 W/cm², and the deposition speed is 0.1 to 30 A/sec.

The raw material gas adaptable to deposit the element in group IV or the alloy type amorphous semiconductor layer in group IV for the photovoltaic device according to the present invention is exemplified by a compound which contains silicon atoms and which can be gasified, a compound which contains germanium atoms and which can be gasified, a compound which contains carbon atoms and which can be gasified, a compound which contains nitrogen atoms and which can be gasified, and a compound which contains oxygen atoms and which can be gasified, and their mixture gas.

Specifically, the compound which contains silicon atoms and which can be gasified is exemplified by SiH₄, Si₂H₆, SiF₄, SiFH₃, SiF₂H₂, SiF₃H, Si₃H₈, SiD₄, SiHD₃, SiH₂D₂, SiH₃D, SiFD₃, SiF₂D₂, SiD₃H and Si₂D₃H₃.

Specifically, the compound which contains germanium atoms and which can be gasified is exemplified by GeH₄, GeD₄, GeF₄, GeFH₃, GeF₂H₂, GeF₃H, GeHD₃, GeH₂D₂, GeH₃D, Ge₂H₆ and Ge₂D₆.

Specifically, the compound which contains carbon atoms and which can be gasified is exemplified by CH₄, CD₄, CₙH₂ₙ₊₂ (n is an integer), CₙH₂ₙ (n is an integer), C₂H₂, C₆H₆, CO₂, and CO.

Specifically, the compound which contains nitrogen atoms and which can be gasified is exemplified by N₂, NH₃, ND₃, NO, NO₂, and N₂O.

Specifically, the compound which contains oxygen atoms and which can be gasified is exemplified by O₂, CO, CO₂, NO, NO₂, N₂O, CH₃CH₂OH and CH₃OH.

The material to be introduced into the p-type layer or the n-type layer to control the valence electrons is exemplified by atoms in group III of the periodic table and atoms in group V.

As for an effective starting material for introducing atoms in group III, a starting material for introducing boron atoms is exemplified by boron hydride such as B₂H₆, B₄H₁₀, B₅H₉, B₅H₁₁, B₆H₁₀, B₆H₁₂ and B₆H₁₄, and boron halide such as BF₃ and BCl₃. Furthermore, AlCl₃, GaCl₃, InCl₃ and TlCl₃ are exemplified. In particular, it is preferred to employ B₂H₆ or BF₃.

As for an effective starting material for introducing atoms in group V, a starting material for introducing phosphorus atoms is exemplified by phosphorus hydride such as PH₃ and P₂H₄, and phosphorus halide such as PH₄I, PF₃, PF₅, PCl₃, PCl₅, PBr₃, PBr₅ and PI₃. Furthermore, any one of the following materials may be employed: AsH₃, AsF₃, AsCl₃, AsBr₃, AsF₅, SbH₃, SbF₃, SbF₅, SbCl₃, SbCl₅, BiH₃, BiCl₃ and BiBr₃. It is preferable that PH₃ or PF₃ is employed.

The foregoing compound which can be gasified may be diluted adequately by H₂, He, Ne, Ar, Xe or Kr gas followed by introduction into the deposition chamber.

If the microcrystalline semiconductor or a-SiC:H which does not considerably absorb light or having a wide band gap is deposited, it is preferable that the raw material gas is diluted with a hydrogen gas by 2 to 100 times, and a relatively large microwave power or RF power is introduced.

### (Collecting Electrode)

The collecting electrode 105 according to the present invention is formed in a portion of the transparent electrode 103 if the resistivity of the transparent electrode 103 cannot be lowered sufficiently. The collecting electrode 105 reduces the series resistance of the photovoltaic device by lowering the resistivity of the electrode. The material of the collecting electrode 105 is exemplified by metal such as gold, silver, copper, aluminum, nickel, iron, chrome, molybdenum, tungsten, titanium, cobalt, tantalum, niobium, zirconium, or an alloy such as stainless steel, or conductive paste composed of granular metal.

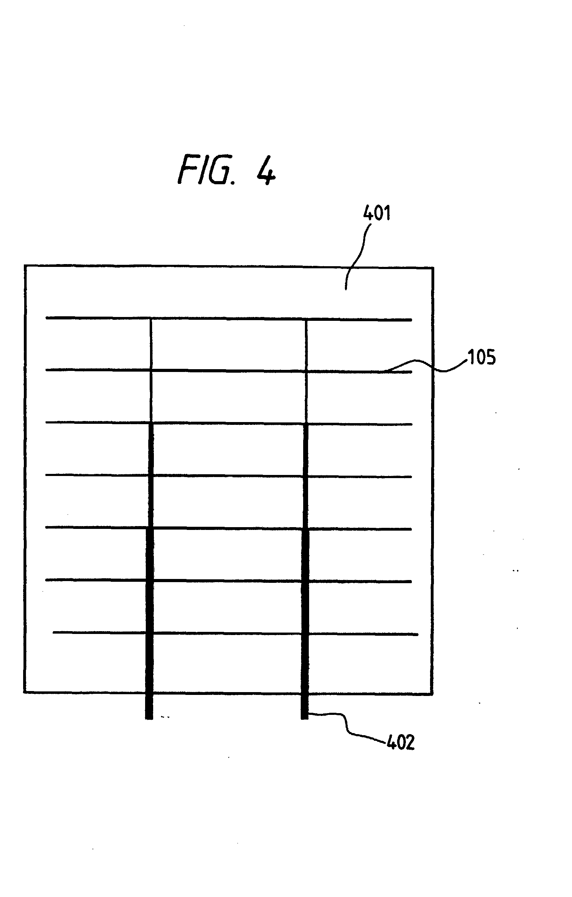

The collecting electrode 105 is formed into, for example, a branch shape as shown in Fig. 4 in order not to shield light incident on the semiconductor layer.

It is preferable that the area of the collecting electrode is 15 % or less of the area of the photovoltaic device, more preferably 10 % or less, most preferably 5 % or less.

The method of forming the collecting electrode is exemplified by: a sputtering method which employs a mask pattern; a resistance heating method; a CVD evaporation method; a method comprising the steps of evaporating a metal layer on the entire surface and patterning a shape by etching the metal layer; a method in which the grid electrode pattern is directly formed by the optical CVD method; a method comprising the steps of forming a mask of the negative pattern of the electrode pattern followed by forming the collecting electrode by plating; and a method of forming the same by printing conductive paste. The conductive paste is prepared by, for example, dispersing the foregoing granular metal into a binder polymer. The binder polymer is exemplified by a polyester resin, epoxy resin, acrylic resin, alkyd resin, polyvinyl acetate resin, rubber, urethane, and phenol resin.

### (Reverse Electrode and Light Reflective Layer)

The reverse electrode 106 according to the present invention is an electrode disposed on the reverse side of the semiconductor layer with respect to the light incidental direction. The reverse side electrode 106 is made of any one of the following materials: gold, silver, copper, aluminum, nickel, iron, chrome, molybdenum, tungsten, titanium, cobalt, tantalum, niobium, zirconium, or an alloy such as stainless steel. It is preferable that metal such as aluminum, copper, silver or gold revealing high reflectivity is employed. If metal revealing high reflectivity is employed, the reverse electrode is able to also serve as a light reflective layer which again reflects light, which has not been absorbed by the semiconductor layer, to the semiconductor layer.

Although the reverse electrode may be formed into flat, it is preferable that the reverse electrode is formed into a shape having projections and pits capable of scattering light. The shape having the projection and pits capable of scattering long wavelength light, which cannot be absorbed by the semiconductor layer, causes the optical path to be lengthened. As a result, the sensitivity of the photovoltaic device to sense the long wavelength light is improved, causing the short-circuit current to be enlarged. Therefore, the efficiency of the photoelectric conversion can be improved. It is preferable that the projections and pits for scattering light has an arrangement that the difference Rmax between the top and the bottom of the projections and the pits is ranged from 0.2 µm to 2.0 µm.

However, the necessity of forming the reverse electrode can be sometimes eliminated if the substrate also serves as the reverse electrode.

The reverse electrode can be formed by an evaporation method, a sputtering method, a plating method and a printing method. The reverse electrode can be formed into the shape having the projections and pits capable of scattering light by dry etching, wet etching, sand blasting or heating the formed metal or alloy film. The shape having the projections and pits capable of scattering light can be formed by evaporating the foregoing metal or alloy while heating the substrate.

### (Substrate)

The material of the substrate 107 according to the present invention may either a conductive material or an insulating material. The conductive material may be molybdenum, tungsten, titanium, cobalt, chrome, nickel, copper, tantalum, niobium, zirconium, or aluminum, and their alloys formed into a plate or a film. In order to improve corrosion resistance, it is preferable that stainless steel, nickel chrome alloy, and sole metal and/or alloy of nickel, tantalum, niobium, zirconium and titanium is employed. Another arrangement that a conductive layer is formed in the insulating material may be employed.

The insulating material may be a synthetic resin film or sheet made of polyester, polyethylene, polycarbonate, cellulose acetate, polypropylene, polyvinyl chloride, polyvinylidene chloride, polystyrene, or polyamide; or a plate-like inorganic insulating material such as glass, ceramics or quartz. A material manufactured by coating an insulating material on a conductive material may be employed.

If a crystalline semiconductor layer is employed, the necessity of forming the substrate 107 can be sometimes omitted by using the crystalline semiconductor as the substrate.

### (Reverse Side Protection Layer)

The reverse side protection layer 108 is provided to protect the reverse side of the photovoltaic device, and is made of a material revealing weather resistance and selected from synthetic resins.

The reverse side protection layer 108 can be formed by bonding the foregoing material in the form of the film to the photovoltaic device after the film material has been deaerated, or by applying, to the photovoltaic device, the material melted with heat or dissolved in a solvent.

Then, a method of manufacturing the photovoltaic device according to the present invention will now be described.

When the photovoltaic device according to the present invention is manufactured, each of the layers constituting the photovoltaic device is formed as described above. The layers are formed in the following sequential order: first the substrate 107 is cleaned, and the reverse electrode 106, the semiconductor layer 104, the transparent electrode 103 and the collecting electrode 105 are sequentially formed. Then, an output outlet electrode (omitted from illustration) is formed, and the surface protection layer 101 including the reverse protection layer 108 and the granules 102 is formed.

However, the aforesaid order is sometimes disordered if the substrate 107 is not used by the semiconductor layer 104 is used as the substrate.

Furthermore, another method may be employed in which the substrate having the collecting electrode and member formed prior to forming the collecting electrode is bonded to the support member on a flat plate and then protection layers are formed on both sides if photovoltaic devices formed on a plurality of substrates are connected in series or in parallel.

### [Examples]

Examples of the present invention will now be described. The present invention is not limited to the descriptions made about the examples.

### Example 1

First, an amorphous silicon (hereinafter called "a-Si") photovoltaic device was manufactured. Then, the manufacturing process will now be described.

An Al film having a thickness of 500 nm and a ZnO film having a thickness of 500 nm were, as the reverse electrode 206, formed on the cleaned stainless-steel substrate 207 by a sputtering method. Then, a CVD method was employed so that the following layers were sequentially formed as follows: an n-type a-Si layer was formed from SiH₄, PH₃ and H₂, and an i-type a-Si layer was formed from SiH₄ and H₂, and a p-type microcrystalline µc-Si layer was formed from SiH₄, BF₃ and H₂. As a result, the semiconductor layer 204 was formed which included an n-layer having a thickness of 15 nm, an i-layer having a thickness of 400 nm, a p-layer having a thickness of 10 nm, an n-layer having a thickness of 10 nm, an i-layer having a thickness of 80 nm, and a p-layer having a thickness of 15 nm.

Then, the transparent electrode 203 was formed by evaporating an In₂O₃ film having a thickness of 70 nm in an O₂ atmosphere by a resistance heating method. Then, an electric current collecting grid electrode 205 was formed by a screen printing method using silver paste. As a result, a photovoltaic device was manufactured.

An outlet portion for the output terminal of the photovoltaic device thus manufactured was masked, followed by sequentially and successively applying the following coatings, each of which has a thickness of 50 µm, to the transparent electrode layer 203 and the collecting electrode 205 by using a roll coaster: a coating in which granules of Al₂O₃·MgO (MgO: 0.05 wt%) having an average size of 0.04 µm were, by 30 wt%, dispersed in a fluororesin coating (pencil hardness in a hardened state: 5H, and refraction factor: 1.52) containing Si-O polymer; and a coating in which the same was dispersed similarly by 10 wt%. Then, the photovoltaic device was heated at 160°C for 20 minutes to be hardened, so that a surface protection layer containing transparent ceramic granules and having a thickness of 100 mm was formed. Consequently, a photovoltaic device covered with the coating was obtained.

The photovoltaic device thus manufactured was evaluated as follows:

### (1) Scratching Test

A load of 907 g was applied to a corner of a carbon steel member of a hacksaw to scratch the specimen at a speed of 152.4 ± 30.5 m/s followed by evaluating the performance of the photovoltaic device after scratching.

### (2) Ice Falling Test

An ice ball having a diameter of 25.4 mm was collided at a final velocity to evaluate the performance of the photovoltaic device after the collision.

### (3) Taper-Type wear Resistance Test

The specimen was worn under conditions in conformity with JIS K7204: abrasion ring CS-10 was used; a load of 500 g was applied; number of rotations was 100. The difference in weight caused due to the experiment was evaluated.

### (4) Bending Test

The specimen was wound around a column having a diameter of 20 mm; followed by bent by an angular degree of 180° to evaluate visually the presence of cracks of the coating.

Results of the foregoing experiments will now be described.

The output did not deteriorate due to the scratching test and the ice falling test, and excellent wear resistance was confirmed in the wear resistance test because no significant difference in weight was resulted. In the bending test, no separation and cracks were generated. Furthermore, the specimen was operated stably in a high humidity operation test. In addition, a transmittance of 80 % or higher was resulted as a result of a measurement performed with an integrating sphere type beam transmittance measuring apparatus.

### Example 2

In this example, a photovoltaic device having an arrangement that the semiconductor layer shown in Fig. 2 was made of copper indium selenide.

The copper indium selenide photovoltaic device was manufactured as follows: the conductive substrate was made of stainless steel, and then molybdenum conductive layer was evaporated by a sputtering method to have a thickness of 500 nm. Then, a Cu layer having a thickness of 200 nm and an In layer having a thickness of 400 nm were sequentially formed, and then the substrate was treated in vapor of H₂Se followed by a heat treatment in an atmosphere of argon gas at 400°C. Then, a ZnCd layer having a thickness of 600 nm was evaporate by the sputtering method, so that a semiconductor layer was formed. Then, a ZnO layer was evaporated by the sputtering method to have a thickness of 70 nm, so that a transparent conductive layer was formed. Then, a collecting electrode was formed by screen printing using silver paste, so that the photovoltaic device was manufactured.

Then, the transparent conductive layer and the collecting electrode of the photovoltaic device thus manufactured were applied with a fluororesin coating (pencil hardness in a hardened state: 2H, and refraction factor: 1.4) to have a thickness of 20 µm by a spraying method. Immediately after this, a coating, in which MgO·MNaF (NaF: 0.25 wt%) having an average size of 0.1 µm was, by 50 wt%, dispersed in the foregoing fluororesin coating, was applied to have a thickness of 30 µm. Then, the foregoing fluororesin coating (pencil hardness in a hardened state: 2H, and refraction factor: 1.4) was applied by the similar spraying method to have a thickness of 20 µm. Then, heat treatment at 150°C for 15 minutes was performed, so that a surface protection layer containing transparent ceramic granules in the visible ray region thereof and having a thickness of 70 µm was formed. Consequently, a photovoltaic device applied with the surface coating was manufactured.

The photovoltaic device thus manufactured was evaluated by a method similar to Example 1, resulting as follows:

The output did not deteriorate due to the scratching test and the ice falling test. In the wear resistance test, although a slight weight difference of 2 mg/m² took place in 100 rotations or less, no significant change was not observed afterwards, resulting in excellent wear resistance. In the bending test, no separation and cracks were generated. Furthermore, the specimen was operated stably in a high humidity operation test. In addition, a transmittance of 80 % or higher was resulted as a result of a measurement performed with an integrating sphere type beam transmittance measuring apparatus.

### Example 3

A photovoltaic device according to this example having an arrangement that the semiconductor layer shown in Fig. 2 was made of polycrystalline silicon. First, a stainless steel applied with a Cr coating by a sputtering method was provided. Then, a polycrystalline silicon film having a thickness of about 30 µm was caused to grow, by a liquid layer grow method, at a speed of 0.4 µm per minute on the stainless steel in such a manner that the temperature of a solution in which Si, which had doped Sn, was dissolved in Sn having a purity of 6N was lowered from 1000°C to 900°C at a descending rate of 2° per minute in a furnace having a hydrogen atmosphere. Then, a plasma CVD method was employed to deposit a p-type microcrystal µc-Si layer from SiH₄, BF₃ and H₂, resulting in a junction to be formed. Then, ITO having a thickness of 60 nm was evaporated by a resistance heating method. The collecting electrode was formed by screen-printing silver paste.

The transparent conductive layer and the collecting electrode of the photovoltaic device thus manufactured were applied with the following solution by a dipping method while masking the outlet portion for the output terminal thereof: a solution in which a water solution of water glass (pencil hardness after it had been hardened: 8H and the refraction factor: 1.5) and a fluororesin solution (fluolinate solution having a refraction factor of 1.29) were mixed at a ratio of 1:3 and the average particles size of the water glass was emulsified and dispersed to have an average particle size of 1.2 µm by using a high pressure emulsifying and dispersing machine (a nanomizer system). Then, the applied coating was dried at 80°C for three minutes. After the foregoing operation was repeated three times, the coating was hardened at 120°C for 20 minutes. As a result, a surface protection layer containing transparent ceramic granules in the visible ray region thereof and having a thickness of 60 µm was formed. Since the specific gravity (1.2) of the water glass is smaller than the specific gravity (1.7) of the fluororesin solution, the proportion of the glass granules accumulating to the surface is raised at this time. Thus, a photovoltaic device applied with the coating was manufactured.

The photovoltaic device thus manufactured was evaluated by a method similar to Example 1, resulting in:

The output did not deteriorate due to the scratching test and the ice falling test, and excellent wear resistance was confirmed in the wear resistance test because no significant difference in weight was resulted. In the bending test, no separation and cracks were generated. Furthermore, the specimen was operated stably in a high humidity operation test. In addition, a transmittance of 80 % or higher was resulted as a result of a measurement performed with an integrating sphere type beam transmittance measuring apparatus.

### Example 4

The transparent electrode and the collecting electrode of the photovoltaic device thus manufactured were applied with the following coatings in the following manner: a coating, in which MgF₂ (average particle size: 1.0 µm) was dispersed by 40 wt% in an acrylic resin (pencil hardness after it has been hardened: 2H and refraction factor: 1.45), and coating in which ThO₂·Y₂O₃ (Y₂O₃: 5 mol%) was dispersed in the foregoing acryl resin by 40 wt% were prepared; and then, the coatings were applied by a tandem type dye-coater to each have a thickness of 30 µm in such a manner that the coating containing ThO₂·Y₂O₃ was formed adjacent to the photovoltaic device. The applied coatings were hardened with ultraviolet rays, so that a surface protection layer containing transparent ceramic granules in a transparent light region having a thickness of 60 µm was formed. Consequently, a photovoltaic device applied with the coating was manufactured.

The photovoltaic device thus manufactured was evaluated by a method similar to Example 1, resulting in: the output did not deteriorate due to the scratching test and the ice falling test, and excellent wear resistance was confirmed in the wear resistance test because no significant difference in weight was resulted. In the bending test, no separation and cracks were generated. Furthermore, the specimen was operated stably in a high humidity operation test. In addition, a transmittance of 90 % or higher was resulted as a result of a measurement performed with an integrating sphere type beam transmittance measuring apparatus. The reason for this can be considered that the fact that MgF2 had a small refraction factor of 1.39 reduces the surface reflection.

### Comparative Example 1

An ethylne-tetrafluoroethylene copolymer film having a thickness of 25 mm and EVA having a thickness of 500 mm were used as the fluororesin film in place of the fluororesin coating according to Example 1 and containing the transparent ceramic granules in the visible ray region thereof to cover the photovoltaic device. Consequently, a photovoltaic device was manufactured.

The photovoltaic device thus manufactured was evaluated by a method similar to Example 1, resulting in: the output did not deteriorate due to the scratching test and the ice falling test. A weight difference of 10 mg/m² took place in the wear resistance test, resulting in unsatisfactory wear resistance. In the bending test, a local separation took place between the fluororesin film and the EVA.

### Comparative Example 2

The process according to Example 3 in which mixing, emulsification and dispersion of the water solution of the water glass was omitted, but a fluororesin coating solution was applied. Then, the coating was heated and hardened at 80°C for 5 minutes, so that a fluororesin layer having a thickness of 60 µm was formed. Consequently, a photovoltaic device applied with the coating was manufactured.

The photovoltaic device thus manufactured was evaluated by a method similar to Example 1, resulting in: the output did not deteriorate considerably due to the ice falling test. A deterioration in the output of 30 % took place in the scratching test. A weight difference of 15 mg/m² took place, in the wear resistance test, resulting in unsatisfactory wear resistance. In the bending test, a local separation took place between the fluororesin layer and the transparent electrode layer of the photovoltaic device.

As the results of Examples 1 and 4 and Comparative Examples 1 and 2, the photovoltaic device according to the present invention is able to be durable against scratching, and reveals excellent bending resistance and wear resistance.

### Example 5

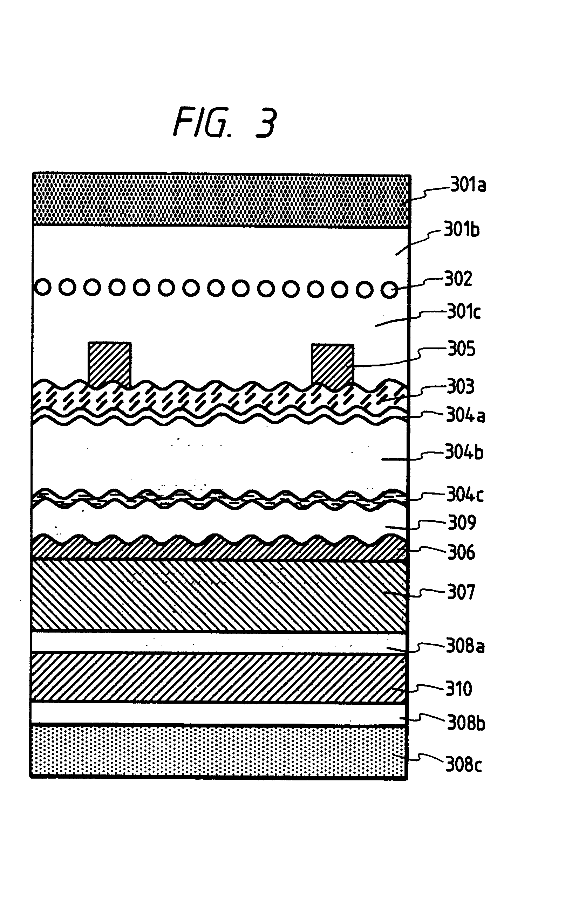

Fig. 3 is a schematic cross sectional view which illustrates an example of the photovoltaic device according to the present invention. The photovoltaic device shown in Fig. 3 has the semiconductor layer made of a-Si and amorphous silicon germanium (hereinafter abbreviated to "a-SiGe"). This example has an arrangement that granules in the form of a layer are formed in the surface protection layer.

Referring to Fig. 3, reference numerals 301a, 301b and 301c represent surface protection layers which are categorized to an upper transparent member 301a and adhesive layers 301b and 301c depending upon the function. Reference numeral 302 represents granules having the density variation in the thickness direction of the surface protection layer according to the present invention, 303 represents a transparent electrode, 304a, 304b and 304c represent semiconductor layers, 305 represents a collecting electrode, 306 represents a reverse electrode, 307 represents a substrate, 308a and 308b represent adhesive layers, and 308c represents a reverse protection layer. Reference numeral 309 represents a transparent conductive layer, and 310 represents an insulating layer. This embodiment has an arrangement that the transparent conductive layer 309 is provided to prevent dispersion of the reverse electrode 309 in the semiconductor layer 304 so as to improve the manufacturing yield of the photovoltaic device, and to enhance the scatter of light of the reverse electrode 309.

The photovoltaic device according this example of the present invention was manufactured by the following process.

First, a stainless steel substrate SUS 304 having a surface roughness (Rmax) of 0.1 µm or less, a thickness of 0.7 mm and a size of 10 cm x 10 cm and serving as the substrate 307 was cleaned. Then, Ag serving as the reverse electrode 306 was formed to have an average thickness of 0.4 µm by an RF sputtering method. By performing sputtering while heating the substrate at 380°C, a shape having projections and pits capable of scattering light of 0.6 µm Rmax was formed.

Then, zinc oxide (ZnO) was formed by using a DC magnetron sputtering apparatus to have a thickness of 0.4 µm.

Then, the following semiconductor layers were formed by a known glow discharge method (a GD method) in which RF waves of 13.56 MHz were applied to the electrode to make the raw material gas plasma state under a lowered pressure so that the raw material gas was decomposed.

First, monosilane (SiH₄) and phosphine (PH₃) diluted by H₂ were decomposed while heating the substrate at 300°C, so that an n-type a-Si layer 304c having a thickness of 20 nm was formed on the substrate on which the ZnO layer and the other layers to be formed prior to forming the ZnO layer were formed. Then, monosilane (SiH₄) and german (GeH₄) diluted by H₂ were decomposed while heating the substrate at 250°C, so that an i-type a-SiGe layer 304b was formed on the n-type a-Si layer 304c to have a thickness of 250 nm (an evaluation of an i-type a-SiGe formed on the glass substrate and having a thickness of 1 mm under the same film forming conditions resulted in an optical band gap (Eg) of 1.45 eV).

The i-type a-SiGe layer 304b has buffer layers each having a thickness of 30 nm adjacent to the n-layer and the p-layer, the buffer layers being layers in each of which a-SiGe is continuously changed to a-Si.

Then, monosilane (SiH₄) and boron trifluoride (BF₃) were decomposed while heating the substrate at 200°C, so that p-type microcrystal silicon layer 304a was formed to have a thickness of 5 nm.

Then, a resistance heating and evaporating method was employed ITO was evaporated to have a thickness of 70 nm while heating the substrate at 170°C, so that the transparent electrode 303 was formed. Then, an electron beam evaporation method was employed to evaporate Al on the transparent electrode 401 to have a pattern as shown in Fig. 4 while using a mask, so that the collecting electrodes 105 and 402 were formed.

Then, outlet electrodes (omitted from illustration) were formed at end portions of the reverse electrode and the collecting electrode.

Then, EVA (ethylene vinylacetate) was melted with heat at 80°C and it was applied to the surface of the photovoltaic device in which the outlet electrodes and the layers to be formed prior to forming the outlet electrodes were formed, the EVA being applied to have a thickness of 100 µm. As a result, the surface protection layer 301c was formed.

By employing a gas phase reaction method in which vapor zinc is oxidized, granules 302 made of ZnO were formed. The formed granules 302 were sprayed on the surface protection layer 301c to form a layer. The gas phase reaction conditions were changed at this time, so that granules having different particle sizes were formed. As a result, photovoltaic devices including the granules having different particle sizes were formed. The granules having a particle size larger than 1 µm were formed by oxidizing zinc granules or by crushing ZnO crystals. Furthermore, photovoltaic devices in which the density of spraying the granules having an average particle size of 0.5 µm is varied were formed.

Then, a PVF film serving as the upper transparent member 301a and having a thickness of 40 µm was bonded to the surface of the granules 302 with EVA 301b (having a refraction factor of 1.5) having a thickness of 100 µm. As a result, the granules 302 were formed in the surface protection layer.

Then, a nylon film having a thickness of 50 µm and serving as the insulating layer 310 and a PVF film having a thickness of 40 µm and serving as the reverse protection layer 308c were bonded to the reverse side of the substrate 307 while interposing EVA films 308a and 308b applied. Then, heat at 150°C for one hour was performed to harden the EVA which forms the adhesive layers. As a result, the photovoltaic device according to this example as shown in Fig. 3 was manufactured. As a result, a so-called single-layer type a-SiGe photovoltaic device having a size of 10 cm x 10 cm was manufactured.

Then, the average of the characteristics of the photovoltaic device having a parallel resistance of 1 KΩ or more per 1 cm² such as the opened voltage (Voc), the short-circuit current (Jsc), the fill factor (FF), and the photoelectric conversion efficiency (η) were measured by using a solar simulator at 25°C to be irradiated with a pseudo solar light of AM1.5 and 100 mw/cm².

Here, 11 types of samples having varied average particles size of ZnO (refraction factor 2.0) disposed to form the layer in the surface protection layer from 0.07 µm to 56 µm were manufactured. At this time, the surface density S of the granules disposed to form the layer was made to be a substantially uniform value of 0.8.

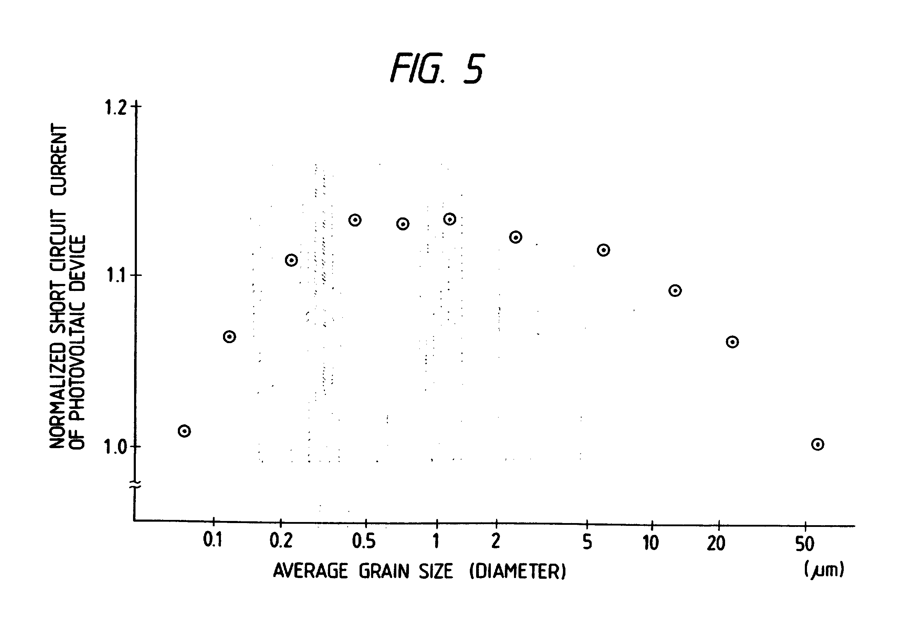

The characteristics of each sample required for the photovoltaic device were measured by the foregoing method. The relationship between the average particle sizes of ZnO and the short-circuit current (Jsc) is shown in a graph of Fig. 5 (where the short-circuit current (Jsc) is a value standardized with the value which was obtained in Comparative Example 3 and which does not include the granules of ZnO to be described later).

As can be seen from Fig. 5, the short-circuit current (Jsc) depends considerably on the average particle size of the ZnO granules. It is preferable that the diameter is from 0.1 µm to 20 µm, more preferably from 0.2 µm to 10 µm, most preferably from 0.3 µm to 5 µm.

Furthermore, 10 types of samples were manufactured which were varied in the surface density S from 0.11 to 0.95 in the case where the ZnO granules having an average particle size of 0.41 µm were disposed to form a layer on the EVA layer.

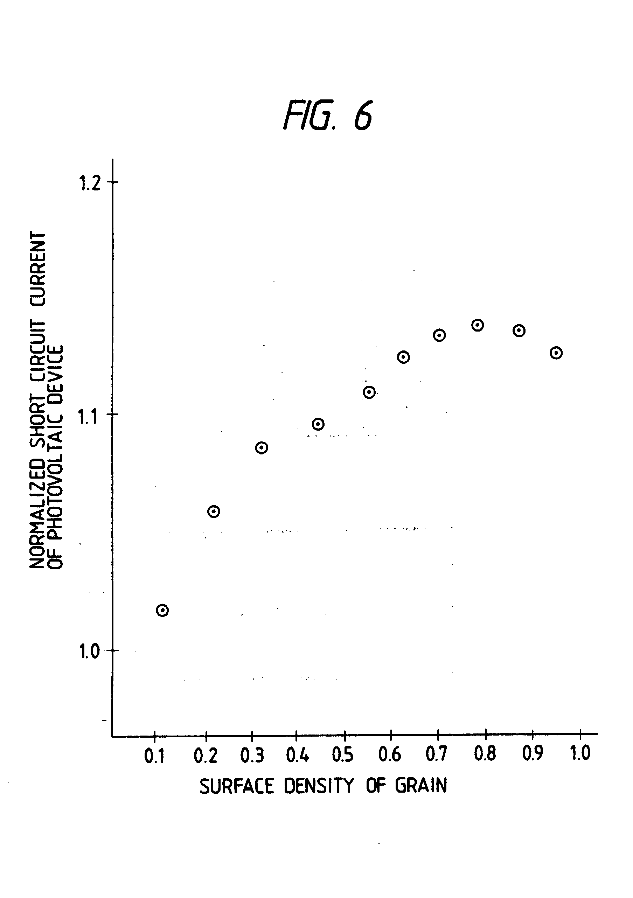

The characteristics of each sample required as the photovoltaic device were measured similar to the foregoing measurement. The relationship between the surface density S of ZnO and the short-circuit current (Jsc) is shown in a graph of Fig. 6 (where the short-circuit current (Jsc) is a value standardized with the value which was obtained in Comparative Example 3 and which does not include the granules of ZnO to be described later).

As can be seen from Fig. 6, the short-circuit current (Jsc) considerably depends upon the surface density S of the granules. It is preferable that the value of the surface density S is 0.2 or more, more preferably 0.4. It can be considered that scatter of light cannot take place satisfactorily if the surface density of the granules is too low. If the surface density is higher than 0.9, the scatter of light took place satisfactorily. However, the adhesivity of the surface protection layer on the granules disposed to form a layer deteriorated.

Results of the evaluation of the characteristics of the samples required as the photovoltaic device in which the ZnO granules having an average particle size of 1.1 µm were disposed to form a layer at a surface density of 0.78 are shown in Table 1 (however, the characteristics required for the photovoltaic device are standardized with the values obtained in Comparative Example 3 to be described later).

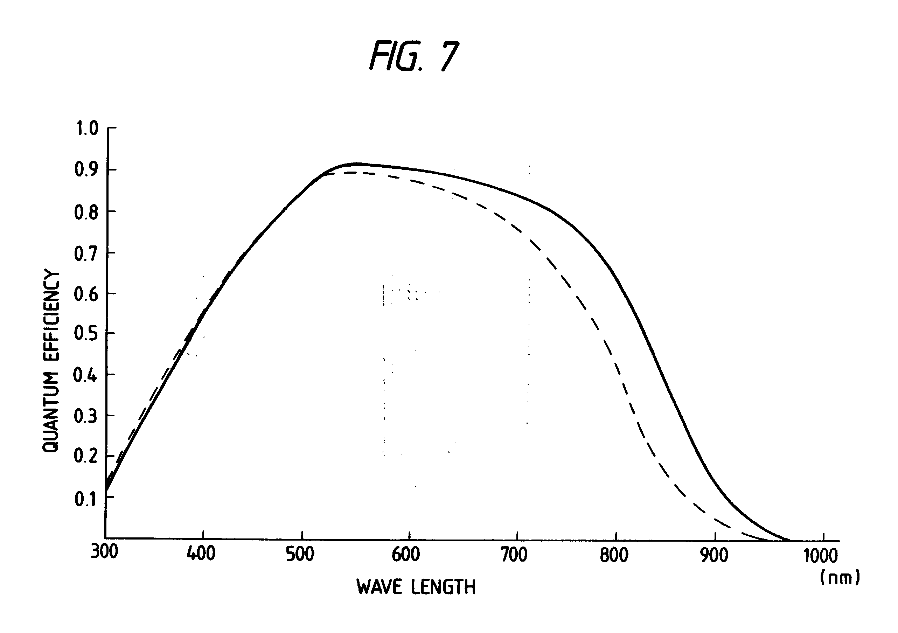

The spectrum sensitivity of the photovoltaic device were measured, resulting in as designated by a solid line of Fig. 7. The axis of ordinate of Fig. 7 stands for the ratio (quantum efficiency) of photons taken out as an electric current with respect to the photons made incident on the photovoltaic device.

### Comparative Example 3

Ten so-called single layer a-SiGe photovoltaic devices having the size 10 cm x 10 cm were manufactured in such a manner that the granules 302 according to Example 5 were not mixed with the surface protection layer and the residual arrangement was made to be the same as that according to Example 1.

The characteristics which must be attained by the photovoltaic device were measured and evaluated with the average value of the measured value similarly to Example 5. Furthermore, the spectrum sensitivity of the photovoltaic device was measured similarly to Example 5, resulting in as designated by a dashed line of Fig. 7.

As can be seen from Fig. 7 and Table 1, the photovoltaic device in which the granules were disposed to form the layer in the surface protection layer exhibited improved spectrum sensitivity in the long wavelength region, a satisfactory short-circuit current (Jsc) was obtained, and the photoelectric conversion efficiency (η) was improved as a result of a comparison made between Example 5 and Comparative Example 3.

**Table 1**

| Example | Example 5 | Comparative Example 3 |
|---|---|---|
| Granules | Present | Not present |
| Voc | 1.001 | 1 |
| Jsc | 1.128 | 1 |
| FF | 1.042 | 1 |
| η | 1.175 | 1 |

### Reference Example 6

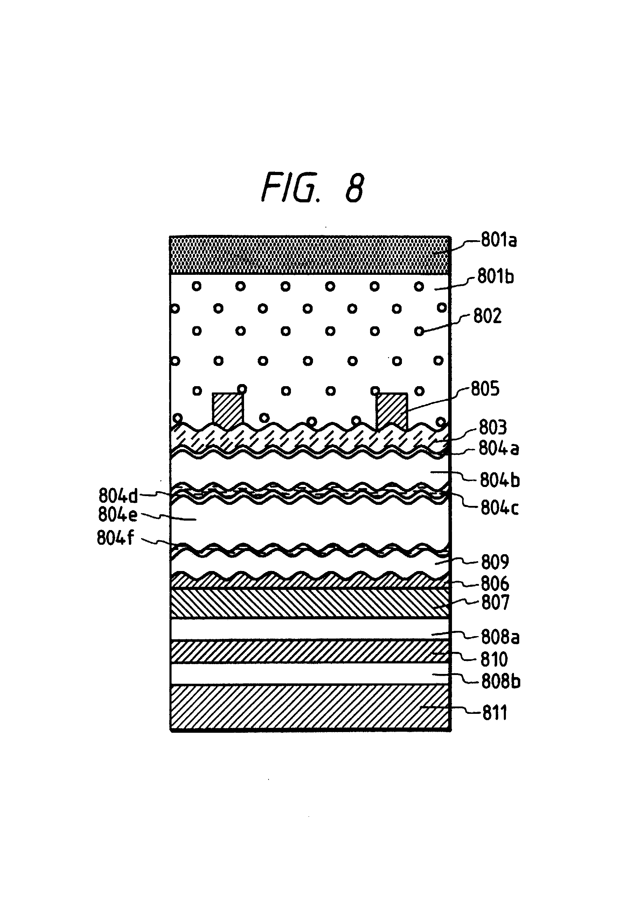

A photovoltaic device shown in Fig. 8 was manufactured by the following process.

Fig. 8 illustrates a stack-type photovoltaic device constituted by stacking two pin junctions. Referring to Fig. 8, reference numerals 801a and 801b represent surface protection layers which are categorized to an upper transparent member 801a and an adhesion layer 801b depending upon the functions. Reference numeral 802 represents granules, 803 represents a transparent electrode, 804a, 804b, 804c, 804d and 804f represent semiconductor layers, 805 represents a collecting electrode, 806 represents a reverse electrode, 807 represents a substrate, and 808a and 808b represent adhesive layers. Reference numeral 809 represents a transparent conductive layer, 810 represents an insulating layer, and 811 represents a support member also serving as a reverse side protection layer. The transparent conductive layer 809 according to this embodiment acts similarly to Example 5.

The photovoltaic device of Fig. 8 shows an arrangement wherein the granules 802 are uniformly distributed in the surface protection layer 801.

As the substrate 807, a stainless steel substrate formed into a sheet exhibiting surface roughness Rmax of 0.1 µm or less, a thickness of 0.15 mm, width of 32 cm and a length of 15 m was cleaned and subjected to the following process by a so-called roll-to-roll method in which the process was performed while continuously moving the substrate from delivery rolls to winding rolls.

First, an RF magnetron sputtering apparatus using an RF of 13.56 MHz was used to form the reverse electrode 806 having an average thickness of 0.4 µm by using Ag as material. By performing sputtering while heating the substrate at 380°C at this time, a shape having projections and pits capable of scattering light of 0.6 µm Rmax was manufactured. Then, zinc oxide (ZnO) was formed to have a thickness of 0.4 µm by the foregoing RF sputtering method, so that the transparent conductive layer 809 was formed.

Then, a glow discharge method (GD method) was employed, so that the following semiconductor layers were formed. First, the a-Si layer 804f, which was a first n-type semiconductor, was formed while heating the substrate at 300°C. Then, the a-SiGe layer 804e, which was a first i-type semiconductor, was formed on the a-Si layer 804f while heating the substrate at 280°C. When an i-type a-SiGe layer deposited on a glass substrate to have a thickness of 1 µm under the same film forming conditions was evaluated, an optical band gap (Eg) of 1.44 eV was exhibited.

Furthermore, the i-type a-SiGe layer 804e included, adjacent to the n-layer and the p-layer, so-called buffer layers in which a-SiGe was continuously changed to a-Si and which has a thickness of 30 nm.

Then, the following layers were consecutively formed as follows: the microcrystal silicon layer 804d, which was a first p-type semiconductor, was formed to have a thickness of 5 nm while heating the substrate at 260°C; the a-Si layer 804c, which was a second n-type semiconductor was formed to have a thickness of 20 nm while heating the substrate at 240°C; the a-Si layer 804b, which was a second i-type semiconductor, was formed to have a thickness of 220 nm while heating the substrate at 240°C; the microcrystal silicon layer 804a, which was a second p-type semiconductor, was formed to have a thickness of 4 nm while heating the substrate at 200°C.

Then, a DC magnetron sputtering apparatus was used to evaporate ITO to have a thickness of 70 nm while heating the substrate at 170°C. As a result, the transparent electrode 803 was formed, and then the photovoltaic device was separated into sections each having a size 10 cm x 10 cm. Then, the substrate was cut along etching lines. Then, an electron beam evaporating method was employed to evaporate Al to form a pattern as shown in Fig. 4. As a result, the collecting electrode 805 was formed. Then, outlet electrodes (omitted from illustration) were connected to the end portion of the reverse electrode and that of the collecting electrode.

Then, EVA melted at 80°C was applied to the supporting member made of a steel plate applied with zinc plating and having a thickness of 0.30 mm. Then, a nylon film serving as the insulating layer 810 and having a thickness of 50 mm was bonded on the supporting member 811. Then, EVA was applied on the insulating layer 810, and a photovoltaic device in which the collecting electrode 805 and the other layers to be formed prior to forming the collecting electrode 805 was bonded on the EVA layer.

By employing a gas phase reaction method in which zinc vapor is oxidized, ZnO granules 802 were formed and mixed with EVA melted at 80°C. Eleven types of samples having volume density V of the granules contained in EVA forming the surface protection layer varied from 0.0006 to 0.52 were manufactured by changing the quantity of mixed ZnO granules. Furthermore, the average particle size of the ZnO granules was made to be 1.1 µm.

Then, EVA with which the ZnO granules were mixed and which had a thickness of 150 µm was applied to the surface of the photovoltaic device in which the collecting electrode 805 and the other layers to be formed prior to forming the collecting electrode 805 were formed. Then, a PVF film having a thickness of 40 mm and serving as the upper transparent member 801a was bonded to the EVA, so that a photovoltaic device having a layer structure as shown in Fig. 8 was formed. Finally, the overall body was heated at 150°C for one hour, so that the EVA forming the adhesive layer was hardened. Consequently, the photovoltaic device as shown in Fig. 8 was manufactured. As a result of the foregoing process, ten Si/SiG₂ 2-stack-type photovoltaic devices each having a size of 10 cm x 10 cm were manufactured.

Then, the average of the characteristics of the photovoltaic device having a parallel resistance of 1 KΩ or more per 1 cm² such as the opened voltage (Voc), the short-circuit current (Jsc), the fill factor (FF), and the photoelectric conversion efficiency (η) were measured by using a solar simulator at 25°C to be irradiated with a pseudo solar light of AM1.5 and 100 mw/cm².

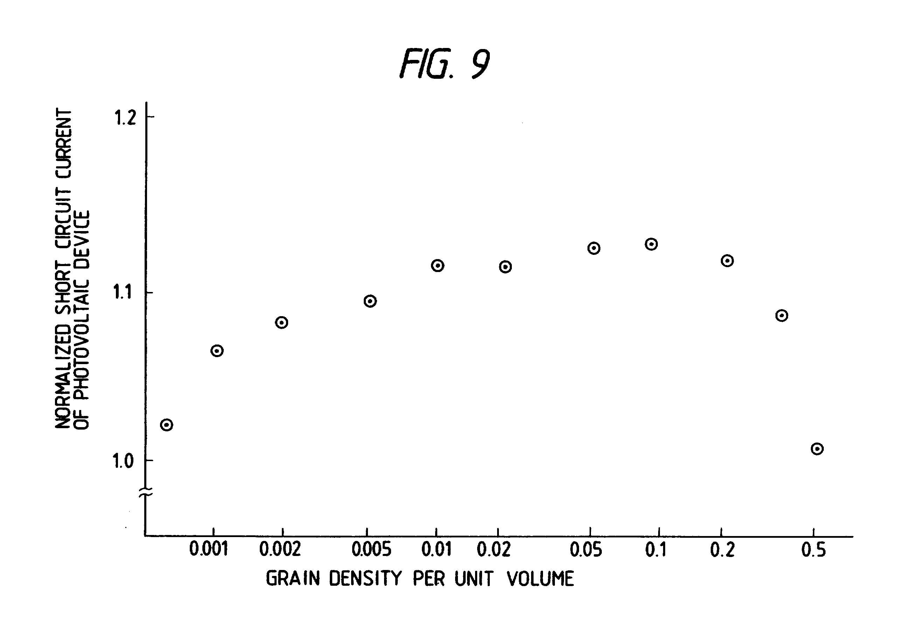

The relationship between the density per volume- of the granules and the short-circuit current (Jsc) of the photovoltaic devices having surface protection layers in which the volume density V of the ZnO granules were changed is shown in a graph of Fig. 9 (where the short-circuit current (Jsc) is a value standardized with the value which was obtained in Comparative Example 4 and which does not include the granules of ZnO to be described later).

As can be seen from Fig. 9, it is effective that the volume density V is from 0.001 to 0.5, preferably from 0.01 to 0.3. The reason for this is that the scatter of light due to the granules is insufficient if the density of the granules in the surface protection layer is too low. If the density is too high, the total transmittance of the surface protection layer deteriorates.

Results of the evaluation of the characteristics of the samples required as the photovoltaic device in which the ZnO granules having an average particle size of 1.1 µm were mixed with the EVA at a volume density of 0.09 are shown in Table 2 (however, the characteristics required for the photovoltaic device are standardized with the values obtained in Comparative Example 4 to be described later).

### Comparative Example 4

Ten so-called Si/SiGe two-layer stack-type photovoltaic devices each having a size 10 cm x 10 cm were manufactured by a method similar to Example 6 except for the granules 802 were not formed. Similarly to Example 6, the characteristics required for the photovoltaic device were measured and evaluated with their average values.

As can be seen From Table 2, the photovoltaic device according to the present invention and including granules which have projections and pits in the surface protection layer improved the short-circuit current (Jsc) of the SiGe cell, causing the total short-circuit current (Jsc) and the fill factor (FF) to be improved. As a result, the photoelectric conversion efficiency (η) was improved.

**Table 2**

| Example | Example 6 | Comparative Example 4 |
|---|---|---|
| Granules | Present | Not present |
| Voc | 1.001 | 1 |
| Jsc | 1.128 | 1 |
| FF | 1.042 | 1 |
| η | 1.175 | 1 |

### Example 7

A photovoltaic device according to Example 7 of the present invention was manufactured by the following process.

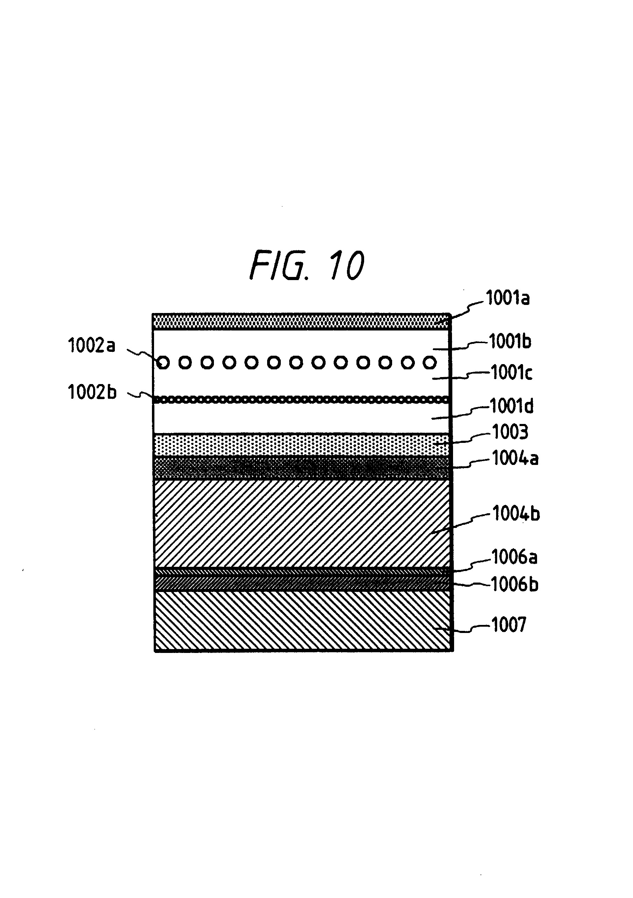

Fig. 10 illustrates an example of a photovoltaic device according to the present invention having a semiconductor layer made of an element in group II-VI. This example has an arrangement that granules formed into a plurality of layers are disposed in the surface protection layer. Furthermore, the particle size of the granules disposed to form a plurality of the layers and the surface density are changed.

Referring to Fig. 10, reference numerals 1001a, 1001b, 1001c and 1001d represent surface protection layers which are categorized to an upper transparent member 1001a, and adhesive layers 1001b, 1001c and 1001d depending upon the functions. Reference numerals 1002a and 1002b represent granules having different particle sizes, 1003 represents a transparent electrode, 1004a represents an n-type Cds semiconductor layer, 1004b represents a p-type CdTe semiconductor layer, 1006a and 1006b represent reverse electrodes, and 1007 represents a substrate also serving as a reverse side protection layer. The collecting electrode on the transparent electrode 1003 is omitted from illustration.

As the substrate 1007, a polyethylene terephthalate (PET) film formed into a sheet and exhibiting a surface roughness Rmax of 0.1 µm or less, and having a thickness of 0.18 mm, a width of 32 cm and a length of 10 mm was cleaned. Then, the so-called roll-to-roll method similar to that according to Example 6 was employed so that the following process was performed.

First, a known DC magnetron sputtering apparatus was used to evaporate ITO to have a thickness of 200 nm while heating the substrate at 170°C. As a result, the transparent electrode 1003 was formed. Then, a heating treatment at 120°C for one hour was performed in an atmosphere of N₂. Then, the photovoltaic device was separated into sections each having a size 10 cm x 10 cm by etching, and the substrate was cut along the etching lines. Then, silver paste was screen-printed, and was dried at 125°C, so that the collecting electrode (omitted from illustration) was formed. Furthermore, outlet electrodes (omitted from illustration) were connected to the end portion of the transparent electrode and that of the collecting electrode.

Then, a gas phase reaction method using TiCl₄ + O₂ was employed, so that granules of TiO₂ (refraction factor 2.3) were formed. By changing the temperature at the reaction and the concentration of the reaction gas at this time, two types of granules each having an average particle size of 0.2 µm and 0.7 µm were manufactured.

Then, polyvinyl butyral (PVB) was applied to have a thickness of 100 µm, so that the adhesive layer 1001d was formed. Then, TiO₂ granules 1002b having a thickness of 0.2 µm was uniformly sprayed to form a layer on the applied PVB to have the surface density S of 0.65. Then, PVB to form the adhesive layer 1001c was again applied to have a thickness of 100 µm on the granules 1002b. Then, the TiO₂ granules 1002a having an average particle size of 0.7 µm was uniformly sprayed to form a layer and to have a surface density S of 0.35. Then, silicon resin to form the adhesive layer 1001b was applied to have a thickness of 100 µm. Furthermore, a PVF film having a thickness of 30 µm to serve as the upper transparent member 1001a was bonded at the uppermost position.

As a result, 100 CdS/CdTe photovoltaic devices having a size 10 cm x 10 cm as shown in Fig. 10 were manufactured.

Then, the average of the characteristics of the photovoltaic device having a parallel resistance of 1 KΩ or more per 1 cm² such as the opened voltage (Voc), the short-circuit current (Jsc), the fill factor (FF), and the photoelectric conversion efficiency (η) were measured by using a solar simulator at 25°C to be irradiated with a pseudo solar light of AM1.5 and 100 mw/cm². Results of measurements of the characteristics required for the photovolatic device are shown in Table 3. However, the characteristics required for the photovoltaic device are standardized with the values of Comparative Example 5 to be described later.

### Example 8

By a method similar to Example 7 except for that the second granules 1002a were not used, 100 so-called CdS/CdTe photovoltaic devices each having a size 10 cm x 10 cm were manufactured. The characteristics required for the photovoltaic device were measured similarly to Example 7, and the average values were obtained.

### Comparative Example 5

By a method similar to Example 7 except for that the granules 1002a and 1002b were not used, 100 so-called CdS/CdTe photovoltaic devices each having a size 10 cm x 10 cm were manufactured. The characteristics required for the photovoltaic device were measured similarly to Example 7, and the average values were obtained.

As can be seen from Table 3, the photovoltaic device according to the present invention in which the granules were disposed to form a plurality of layers in the surface protection layer enabled the short-circuit current (Jsc) and the photoelectric conversion efficiency (η) to be improved. Furthermore, the granules disposed to form a single layer were changed to two layers, and the particle size of the granules in the upper layer was made to be larger than that of the granules in the lower layer to make the surface density in the upper layer to be smaller than that in the lower layer. As a result, the scatter of light in the surface protection layer was enhanced while substantially being freed from deterioration in the total transmittance of the surface protection layer. As a result, the length of the optical path in the semiconductor layer was lengthened. As a result, the arrangement that number of the granule layer was increased from one to two enabled the short-circuit current (Jsc) to improved, and the photoelectric conversion efficiency (η) to be improved.

**Table 3**

| Example | Example 7 | Example 8 | Comparative Example 5 |
|---|---|---|---|
| Granules | Double Layer | Single Layer | No Layer |
| Voc | 0.999 | 1.000 | 1 |
| Jsc | 1.143 | 1.089 | 1 |
| FF | 1.002 | 1.001 | 1 |
| η | 1.144 | 1.090 | 1 |

### Example 9

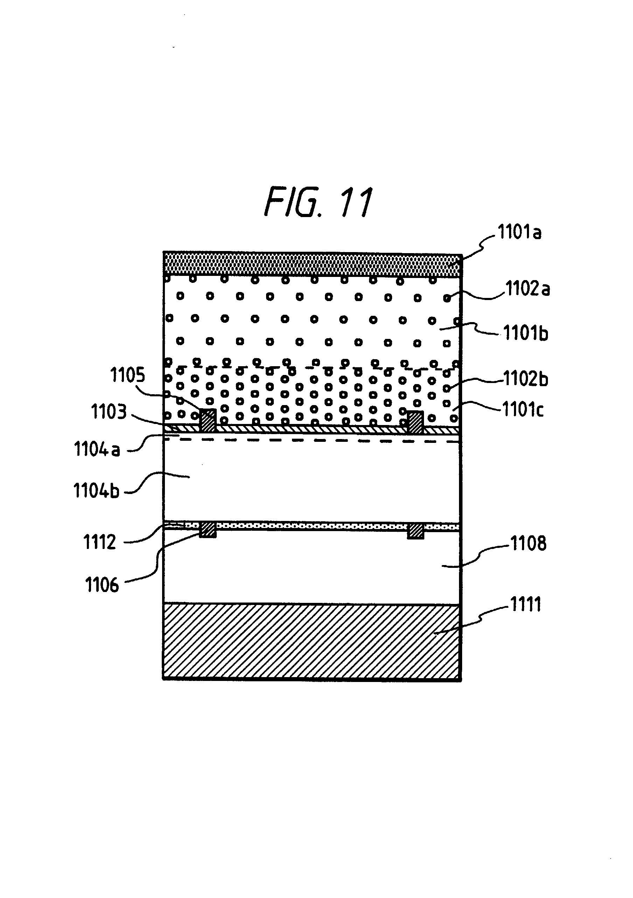

Another example of the photovoltaic device according to the present invention and shown in Fig. 11 was manufactured. This example is characterized in that plural types of surface protection layers depending upon the density of the mixed granules per volume were used.

Fig. 11 illustrates an example of the photovoltaic device according to the present invention in which polycrystal silicon is used to form the semiconductor layers.

Referring to Fig. 11, reference numerals 1101a, 1101b and 1101c represent surface protection layers which are divided depending upon the functions into an upper transparent member 1101a and filler layers 1101b and 1101c. Reference numerals 1102a and 1102b represent granules, 1103 represents a reflection prevention layer or a transparent electrode also serving as a reflection prevention layer, and 1104a and 1104b represent polycrystal silicon semiconductor substrates. The polycrystal silicon semiconductor substrate 1104a represents a portion converted into a portion of a conductive type opposing the semiconductor substrate. Reference numeral 1106 represents a reverse electrode, 1108 represents a reverse-side filler layer, 1111 represents a supporting member also serving as a reverse-side protection layer, and 1112 represents a reverse-side passivation layer of the semiconductor substrate.

First, a p-type polycrystal silicon substrate formed by a casting method was provided, and the surface of the substrate was cleaned. Then, the surface 1104a was converted to n⁺ type layer by an ion injection method, so that a pn junction was formed.

Then, a SiO₂ passivation layer (omitted from illustration) having a thickness of 5 nm was formed on the surface of the polycrystal silicon substrate in which the pn junction was formed. Then, the Si₃N₄ passivation layer 1112 having a thickness of 200 nm was formed on the reverse side of the polycrystal silicon substrate.

Then, Ti and Ag collecting electrode 1105 and reverse electrode 1106 were formed on the two sides of the polycrystal substrate having the passivation layer formed thereon.

A known DC magnetron sputtering apparatus was used to form the transparent electrode 1103 also serving as the reflection prevention layer and having a thickness of 0.2 µm by employing Ta₂O₅ while heating the substrate at 200°C. Furthermore, outlet electrodes (omitted from illustration) were formed at the end portion of the collecting electrode 1105 and that of the reverse electrode 1106.

Then, a gas phase reaction method using SiCl₄ + NH₃ was employed, so that Si₃N₄ granules having an average particle size of 0.3 µm were formed. Then, Si₃N₄ granules were mixed with EVA melted at 80°C. At this time, two types of EVA depending upon the granule volume densities V of 0.05 and 0.005 were manufactured by changing the quantity of the mixed Si₃N₄ granules.

Then, the EVA 1101c having the granule volume density V of 0.05 and a thickness of 100 µm was applied to the photovoltaic device in which the collecting electrode and the other layers to be formed prior to forming the collecting electrode were formed. Then, the EVA 1101b having the granule volume density V of 0.005 and a thickness of 200 µm was applied to the EVA 1101c. Then, a PVF film to serve as the upper transparent member 1101a was bonded to the uppermost position.

Then, EVA to serve as the filler layer 1108 was applied to the supporting member 1111 having a thickness of 1 mm and made of an Al plate, so that the foregoing photovoltaic device was bonded.

Then, the overall body was heated at 150°C for one hour to harden EVA, so that the photovoltaic device according to the present invention shown in Fig. 11 was manufactured. As a result of the foregoing process, 50 polysilicon photovoltaic devices each having a size 10 cm x 10 cm shown in Fig. 11 were manufactured.

Then, the average of the characteristics of the photovoltaic device having a parallel resistance of 1 KΩ or more per 1 cm² such as the opened voltage (Voc), the short-circuit current (Jsc), the fill factor (FF), and the photoelectric conversion efficiency (η) were measured by using a solar simulator at 25°C to be irradiated with a pseudo solar light of AM1.5 and 100 mw/cm². Results of evaluations of the characteristics of the photovoltaic devices are shown in Table 4 (however, the characteristics of the photovoltaic devices are standardized with values of Comparative Example 6 to be described later).

### Example 10

Fifty polycrystal silicon photovoltaic devices each having a size of 10 cm x 10 cm were manufactured by a method similar to Example 9 except for an arrangement that only one layer of EVA having a volume density V of Si₃N₄ granules of 0.02 was applied to have a thickness of 300 µm in place of 1101b and 1101c. Similarly to Example 9, the characteristics of the photovoltaic devices were measured to obtain average values.

### Comparative Example 6

Fifty polycrystal silicon photovoltaic devices each having a size of 10 cm x 10 cm were manufactured by a method similar to Example 4 except for an arrangement that the granules were not mixed with EVA and only EVA was applied to the photovoltaic device to have a thickness of 300 µm. Similarly to Example 9, the characteristics of the photovoltaic devices were measured to obtain average values.

As can be seen from Table 4, the photovoltaic device according to the present invention having Si₃N₄ granules in the surface protection layer thereof improved the short-circuit current (Jsc) and the photoelectric conversion efficiency (η). Furthermore, the structure in which the two layers of the granules were formed improved the short-circuit current (Jsc) and the photoelectric conversion efficiency (η). In addition, use of plural types of surface protection layers in which the volume density V of the granules was changed in the surface protection layer further enhanced the scatter of light as compared with a single-layer structure in which the volume density V was constant. As a result, the length of the optical path in the semiconductor layer can be lengthened. Therefore, the short-circuit current (Jsc) and the photoelectric conversion efficiency (η) were further improved.

**Table 4**

| Example | Example 9 | Example 10 | Comparative Example 6 |
|---|---|---|---|
| Granules | Double Layer | Single Layer | No Layer |
| Voc | 1.000 | 1.001 | 1 |
| Jsc | 1.122 | 1.097 | 1 |
| FF | 1.001 | 1.001 | 1 |
| η | 1.123 | 1.099 | 1 |

### Example 11

Another example of the photovoltaic device according to the present invention shown in Fig. 12 was manufactured by the following process.

This example is an example of the photovoltaic device according to the present invention has the semiconductor layer made of single-crystal GaAs. This example is characterized in that the surface protection layer includes plural types of granules depending upon the material, and plural types of surface protection layers depending upon the particle size and the density per volume of the granules were formed.

First, an n-type GaAs wafer 1204 having a thickness of 200 µm was provided, and an MOCVD method was employed to form an n-type GaAs layer in which sulfur (S) was doped and which had a thickness of 5.0 µm. Then, the MOCVD method was again employed to sequentially form the following layers: a p-type GaAs layer in which Zn was doped and which had a thickness of 0.5 µm; a p-type AlGaAs layer in which Zn was doped and which had a thickness of 0.15 µm; and a p-type GaAs layer in which Zn was doped and which had a thickness of 0.5 µm. As a result, a pn junction was formed.

Then, a reflection prevention layer (omitted from illustration) having a thickness of 75 nm and made of Si₃N₄ was formed on the GaAs wafer 1204 in which the pn junction was formed.

Then, a passivation layer 1212 having a thickness of 200 nm and made of Si₃N₄ was formed on the reverse side of the GaAS wafer. Then, Ti and Ag collecting electrode 1205 and reverse electrode 1206 were formed on the two sides of the GaAs wafer on which the passivation layer 1212 was formed.

Then, the photovoltaic device in which the collecting electrode 1205 and the other layers to be formed prior to forming the electrode 1205 were formed was bonded to a supporting member 1211 having a thickness of 1 mm and made of an Al plate by applying EVA 1208. At this time, outlet electrodes (omitted from illustration) were formed at an end portion of the collecting electrode 1205 and that of the reverse electrode 1206.

On the other hand, magnesium fluoride (MgF₂) granules 1202a obtained by heating magnesium carbonate and hydrofluoric acid was prepared, the MgF₂ granules having an average particle size of about 1.5 µm. The MgF₂ granules were mixed with EVA melted with heat at 80°C to make the volume density V to be 0.005. EVA 1201c mixed with the MgF₂ granules was, to have a thickness of 100 µm, applied to the photovoltaic device in which the collecting electrode 1205 and the other layers to be formed prior to forming the collecting electrode 1202 were formed.

On the other hand, granules 1202b made of ZnS which was white pigment and having an average particle size of 0.7 µm was, together with the foregoing MgF₂ granules 1202a, mixed with EVA melted with heat at 80°. At this time, the density per volume of the MgF₂ granules 1202a in EVA was made to be 0.01 and the density of volume of the ZnS granules 1202b was made to be 0.04. The EVA layer 1201b mixed with the MgF₂ and ZnS granules was applied, to have a thickness of 100 µm, to the EVA layer 1201c with which the foregoing MgF₂ granules were mixed.

Then, the PVF film 1201a which was the upper transparent member was bonded to the EVA layer 1201b while deaerating the PVF film 1201a. Then, the overall body was heated at 150°C for one hour to harden EVA, so that the photovoltaic device according to the present invention shown in Fig. 12 was manufactured. As a result of the aforesaid process, 20 GaAs photovoltaic devices each having a diameter of 3 inches were manufactured.

Then, the average of the characteristics of the photovoltaic device having a parallel resistance of 1 KΩ or more per 1 cm² such as the opened voltage (Voc), the short-circuit current (Jsc), the fill factor (FF), and the photoelectric conversion efficiency (η) were measured by using a solar simulator at 25°C to be irradiated with a pseudo solar light of AM1.5 and 100 mw/cm². Results of measurements of the characteristics required for the photovoltaic device are shown in Table 5. However, the characteristics required for the photovoltaic device are standardized with the values of Comparative Example 7 to be described later.

### Example 12

Twenty GaAs photovoltaic devices each having a diameter of 3 inches were manufactured by a method similar to that according to Example 11 except for an arrangement in which the EVA layer 1201b contained MgF₂ and ZnS granules was not formed but only the EVA layer 1201c containing MgF₂ granules was formed. Similarly to Example 11, the characteristics of the photovoltaic devices were measured to obtain the average values.

### Comparative Example 7

Twenty GaAs photovoltaic devices each having a diameter of 3 inches were manufactured by a method similar to that according to Example 11 except for an arrangement in which the granules are not contained in the EVA layer. Similarly to Example 11, the characteristics of the photovolatic devices were measured to obtain the average values.

As can be seen from Table 5, the photovolatic device according to the present invention having an arrangement that the MgF2 granules are contained in the surface protection layer according to Comparative Example 7 improved the short-circuit current (Jsc) and the photoelectric conversion efficiency (η). Furthermore, use of the surface protection layer containing the plural types of granules such as MgF₂ and ZnS according to Example 11 further improved the short-circuit current (Jsc) and the photoelectric conversion efficiency (η). In addition, the arrangement that the surface protection layer containing the granules having the small particle size and having a small volume density V of the granules in the surface protection layer was formed adjacent to the semiconductor layer improved the adhesivity between the photovoltaic device, in which the collecting electrode 1205 and the other layers to be formed prior to forming the collecting electrode 1205 were formed, and the surface protection layer.

**Table 5**

| Example | Example 11 | Example 12 | Comparative Example 7 |
|---|---|---|---|
| Granules | Double Layer | Single Layer | No Layer |
| Voc | 1.000 | 1.000 | 1 |
| Jsc | 1.105 | 1.037 | 1 |
| FF | 1.001 | 1.001 | 1 |
| η | 1.106 | 1.038 | 1 |

According to the present invention, the arrangement that the hard granules transparent with respect to visible light region are contained in the resin of the surface protection layer protects the photovoltaic device from scratching damage or the like and accordingly prevents deterioration in the performance. Furthermore, the wear resistance can be improved. If resin exhibiting a wide contact angle is used in the outermost surface on the light incident side, contamination of the photovoltaic device taken place outdoors can be prevented. Furthermore, the incident light can be effectively utilized by selecting a combination of granules having an optimum refraction factor and granules. In addition, ultraviolet rays can be absorbed by the granules, causing the deterioration of the photovoltaic member due to light to be prevented. Moreover, the light decomposition of silver paste resin or the like used in the collecting electrode can be prevented. Consequently, a photovoltaic device such as a solar cell module can be provided which exhibits excellent light resistance, bending resistance and flame resistance, and weather resistance and mass production facility.

Furthermore, light which is incident on the photovoltaic device is scattered in the surface protection layer and then the light is incident on the semiconductor layer. Therefore, the length of the optical path in the semiconductor layer can be lengthened, the light absorption in the semiconductor layer can be enhanced, and the short-circuit current can be enlarged. As a result, the photoelectric conversion efficiency can be improved. Consequently, a photovoltaic device capable of stably outputting a high photoelectric conversion efficiency can be provided.

Moreover, the granules are dispersed sparsely or coarsely adjacent to the surface, i.e. in the vicinity of the light incident side, and densely in the inner portion of the surface protection layer with respect to the light incidental direction. Therefore, light can be further considerably scattered, the light absorption by the semiconductor layer can be enhanced, and the short circuit current can be accordingly enlarged. As a result, the photoelectric conversion efficiency of the photovoltaic device can be further improved.

In addition, the fact that the granules are dispersed sparsely or coarsely adjacent to the surface and densely in the inner portion of the surface protection layer with respect to the light incidental direction improves the adhesion between the surface of the photovoltaic device, in which the electrodes and the other layers to be formed prior to forming the electrode are formed, and the surface protection layer.

Furthermore, if the granules are formed into a plurality of layers in the surface protection layer, the incident light can be further effectively scattered, the light absorption by the semiconductor layer can be enhanced, and the short circuit current is accordingly enlarged. As a result, the photoelectric conversion efficiency of the photovoltaic device can be further improved.

Furthermore, the arrangement that plural types of granules depending upon the material are simultaneously used further enhances scattering of incident light, the light absorption by the semiconductor layer can be enhanced, and accordingly the short-circuit current can be enlarged. As a result, the photoelectric conversion efficiency of the photovoltaic device can be further improved.

Moreover, if the difference between the refraction factor of the material of the granules and that of the material of the surface protection layer is made to be 0.1 or more, scattering of incident light is enhanced, light absorption by the semiconductor layer can be enhanced, and accordingly the short-circuit current can be enlarged. As a result, the photoelectric conversion efficiency of the photovoltaic device can be further improved.

In addition, the photovoltaic device according to the present invention can provide a long optical path in the semiconductor layer thereof. Therefore, the light absorption by the semiconductor layer can be enhanced. As a result, the thickness of the semiconductor layer can be thinned. Therefore, if an amorphous semiconductor is employed as the semiconductor layer, generation of defects taken place in the semiconductor layer due to light can be prevented. Therefore, deterioration (so-called light deterioration) in the photoelectric conversion efficiency of the photovoltaic device due to light irradiation can be prevented.

If the crystalline semiconductor is used as the semiconductor layer, the thickness of the semiconductor substrate can be thinned. As a result, the weight of the photovoltaic device can be reduced, and required material of the semiconductor can be reduced, and the cost for manufacturing the photovoltaic device can be reduced.

## Claims

1. A photovoltaic device comprising: a semiconductor layer (104); electrodes (103, 106); a surface protection layer (101) provided at the light incident side; and granules (102) of a material different from the material of the surface protection layer disposed in the surface protection layer, wherein the density per unit volume V of the granules (102) in the surface protection layer (101) is from 0.001 to 0.5 and wherein the granules (102) are dispersed at different density in the thickness direction of the surface protection layer (101), i.e. sparsely in the vicinity of the light incident side of the surface protection layer (101) and densely in the inner portion of the surface protection layer (101) or densely in the vicinity of the light incident side of the surface protection layer (101) and sparsley in the inner portion of the surface protection layer (101).

2. A photovoltaic device according to claim 1, wherein said granules are disposed into a plurality of layers (1101b, 1101c; 1201b, 1201c) in said surface protection layer.

3. A photovoltaic device according to claim 1, wherein two or more types of granules differing in material from each other are used.

4. A photovoltaic device according to claim 1, wherein the difference between the refractive index of the material of the granules and that of the material of the surface protection layer is 0.1 or more.

5. A photovoltaic device according to claim 1 which further comprises a light reflection layer formed at a side opposite to the light incident side of the semiconductor layer, the light reflection layer having a structure for scattering light.

6. A photovoltaic device accordinq to any of the preceding claims, wherein the surface density of said granules in said surface protection layer is from 0.2 to 0.9.

7. A photovoltaic device according to any of the preceding claims, wherein said semiconductor is an amorphous semiconductor.

8. A photovoltaic device according to claim 1, wherein the semiconductor is a non-monocrystalline semiconductor.

9. A photovoltaic device according to claim 1, wherein the granules have a transmittance of not less than 80% for a light of wavelength of 400nm to 1000nm.

10. A photovoltaic device according to claim 1, wherein the granules have a reflective index of 1.0 to 3.0.

11. A photovoltaic device according to any of the preceding claims, wherein the granules in the surface protection layer have an average particle size of 0.001 to 20 µm.

## Patentansprüche

1. Fotovoltaische Vorrichtung mit einer Halbleiterschicht (104), Elektroden (103, 106), einer an der Lichteinfallseite vorgesehenen Oberflächenschutzschicht (101) und in der Oberflächenschutzschicht angeordneten Körnern (102) aus einem Material, das sich von dem Material der Oberflächenschutzschicht unterscheidet, wobei die Dichte pro Einheit Volumen V der Körner (102) in der Oberflächenschutzschicht (101) 0,001 bis 0,5 beträgt und wobei die Körner mit unterschiedlicher Dichte in Dickenrichtung der Oberflächenschutzschicht (101) dispergiert sind, d.h. spärlich in der Nachbarschaft der Lichteinfallseite der Oberflächenschutzschicht (101) und dicht im inneren Abschnitt der Oberflächenschutzschicht (101) oder dicht in der Nachbarschaft der Lichteinfallseite der Oberflächenschutzschicht (101) und spärlich im inneren Abschnitt der Oberflächenschutzschicht (101).

2. Fotovoltaische Vorrichtung nach Anspruch 1, bei der die Körner in eine Vielzahl von Schichten (1101b, 1101c; 1201b, 1201c) in der Oberflächenschutzschicht dispergiert sind.

3. Fotovoltaische Vorrichtung nach Anspruch 1, bei der zwei oder mehr Arten von Körnern verwendet sind, die sich im Material voneinander unterscheiden.

4. Fotovoltaische Vorrichtung nach Anspruch 1, bei der der Unterschied zwischen dem Brechnungsindex des Materiales der Körner und dem des Materiales der Oberflächenschutzschicht 0,1 oder mehr beträgt.

5. Fotovoltaische Vorrichtung nach Anspruch 1, die des weiteren eine Lichtreflexionsschicht umfaßt, die an einer Seite gegenüber der Lichteinfallseite der Halbleiterschicht ausgebildet ist und eine Struktur zur Lichtstreuung besitzt.

6. Fotovoltaische Vorrichtung nach einem der vorangehenden Ansprüche, bei der die Oberflächendichte der Körner in der Oberflächenschutzschicht 0,2 bis 0,9 beträgt.

7. Fotovoltaische Vorrichtung nach einem der vorangehenden Ansprüche, bei der der Halbleiter ein amorpher Halbleiter ist.

8. Fotovoltaische Vorrichtung nach Anspruch 1, bei der der Halbleiter ein nicht-monokristalliner Halbleiter ist.

9. Fotovoltaische Vorrichtung nach Anspruch 1, bei der die Körner eine Durchlässigkeit von nicht weniger als 80 % für Licht mit einer Wellenlänge von 400 nm bis 1000 nm besitzen.

10. Fotovoltaische Vorrichtung nach Anspruch 1, bei der die Körner einen Reflexionsindex von 1,0 bis 3,0 aufweisen.

11. Fotovoltaische Vorrichtung nach einem der vorangehenden Ansprüche, bei der die Körner in der Oberflächenschutzschicht eine durchschnittliche Partikelgröße von 0,001 bis 20 µm besitzen.

## Revendications

1. Dispositif photovoltaïque comportant : une couche (104) de semiconducteur ; des électrodes (103, 106) ; une couche (101) de protection de surface située du côté d'incidence de la lumière ; et des granules (102) d'une matière différente de la matière de la couche de protection de surface disposés dans la couche de protection de surface, dans lequel la densité par unité de volume V des granules (102) dans la couche (101) de protection de surface est de 0,001 à 0,5 et dans lequel les granules (102) sont dispersés à une densité différente dans la direction de l'épaisseur de la couche (101) de protection de surface, c'est-à-dire de façon clairsemée au voisinage du côté d'incidence de la lumière de la couche (101) de protection de surface et de façon dense dans la partie intérieure de la couche (101) de protection de surface ou de façon dense au voisinage du côté d'incidence de la lumière de la couche (101) de protection de surface et de façon clairsemée dans la partie intérieure de la couche (101) de protection de surface.

2. Dispositif photovoltaïque selon la revendication 1, dans lequel lesdits granules sont disposés en plusieurs couches (1101b, 1101c ; 1201b, 1201c) dans ladite couche de protection de surface.

3. Dispositif photovoltaïque selon la revendication 1, dans lequel deux ou plus de deux types de granules de matières différentes entre elles sont utilisés.

4. Dispositif photovoltaïque selon la revendication 1, dans lequel la différence entre l'indice de réfraction de la matière des granules et celui de la matière de la couche de protection de surface est de 0,1 ou plus.

5. Dispositif photovoltaïque selon la revendication 1, qui comporte en outre une couche de réflexion de lumière formée sur un côté opposé au côté d'incidence de la lumière de la couche de semiconducteur, la couche de réflexion de lumière ayant une structure pour diffuser la lumière.

6. Dispositif photovoltaïque selon l'une quelconque des revendications précédentes, dans lequel la densité de surface desdits granules dans ladite couche de protection de surface est de 0,2 à 0,9.

7. Dispositif photovoltaïque selon l'une quelconque des revendications précédentes, dans lequel ledit semiconducteur est un semiconducteur amorphe.

8. Dispositif photovoltaïque selon la revendication 1, dans lequel le semiconducteur est un semiconducteur non monocristallin.

9. Dispositif photovoltaïque selon la revendication 1, dans lequel les granules ont une transmittance non inférieure à 80 % pour une lumière d'une longueur d'onde de 400 nm à 1000 nm.

10. Dispositif photovoltaïque selon la revendication 1, dans lequel les granules ont un indice de réfraction de 1,0 à 3,0.

11. Dispositif photovoltaïque selon l'une quelconque des revendications précédentes, dans lequel les granules dans la couche de protection desurface ont une dimension moyenne de particules de 0,001 à 20 µm.
